# EUROPEAN PATENT APPLICATION

(11) **EP 4 669 074 A1**
(43) Date of publication of application: **24.12.2025**
(21) Application number: 25182973.5
(22) Date of filing: 16.06.2025
(51) Int. Cl.: H10K 59/122

(54) **DISPLAY PANEL, ELECTRONIC DEVICE INCLUDING THE DISPLAY PANEL, AND METHOD OF MANUFACTURING THE DISPLAY PANEL**

(30) Priority: 17.06.2024 KR 20240078443
(71) Applicant: Samsung Display Co., Ltd., Yongin-si, Gyeonggi-do 17113 (KR)
(72) Inventor: YANG, Sukyoung, Yongin-si (KR); PARK, Joonyong, Yongin-si (KR); SONG, Dokeun, Yongin-si (KR); SHIN, Hyuneok, Yongin-si (KR); LEE, Dongmin, Yongin-si (KR)
(74) Representative: Marks & Clerk LLP

(57) **Abstract**

Disclosed is a display panel including a base layer (BL), a pixel defining film (PDL) disposed on the base layer (BL) and having a light emitting opening (OP-e), a partition wall (PW) disposed on the pixel defining film (PDL) and having a partition wall opening (OP-P) overlapping the light emitting opening (OP-E), and a light emitting element (ED) including an anode (AE), an intermediate layer (EP), and a cathode (CE), wherein the cathode (CE) is in contact with the partition wall (PW) and disposed inside the light emitting opening (OP-E) and the partition wall opening (OP-P). The partition wall (PW) includes a first partition wall layer (L1) disposed on the pixel defining film (PDL) and a second partition wall layer (L2) including a plurality of sub-layers (L21-L24) repeatedly disposed on the first partition wall layer (L1), and the first partition wall layer (L1) has an undercut shape with respect to the second partition wall layer (L2).

## Description

### BACKGROUND

Embodiments of the present disclosure relate to a display panel and a method of manufacturing a display panel, and more particularly, a display panel having improved display quality.

Electronic devices such as, for example, televisions, monitors, smart phones, and tablet personal computers (PCs) that provide images to users include display panels that display images. Various display panels such as, for example, liquid crystal display panels, organic light emitting display panels, electro wetting display panels, and electrophoretic display panels have been developed as the display panels.

The organic light emitting display panel may include an anode, a cathode, and a light emitting pattern. The light emitting pattern may be separated for each of light emitting areas, and the cathode may provide a common voltage to each of the light emitting areas.

### SUMMARY

Embodiments of the present disclosure provide a display panel forming a light emitting element without using a metal mask and having improved display quality, and a method of manufacturing the display panel.

According to an embodiment, a display panel includes a base layer, a pixel defining film disposed on the base layer and having a light emitting opening, a partition wall disposed on the pixel defining film and having a partition wall opening overlapping the light emitting opening, and a light emitting element including an anode, an intermediate layer, and a cathode, wherein the cathode is in contact with the partition wall and disposed inside the light emitting opening and the partition wall opening. The partition wall includes a first partition wall layer disposed on the pixel defining film, and a second partition wall layer including a plurality of sub-layers repeatedly disposed on the first partition wall layer, and the first partition wall layer has an undercut shape with respect to the second partition wall layer.

Each of the plurality of sub-layers may include titanium (Ti) or a titanium nitride (TiN).

The partition wall opening may include a first area defined by an inner surface of the first partition wall layer and a second area defined by an inner surface of the second partition wall layer, and a width of the first area in a direction may be greater than a width of the second area in the direction.

A thickness of the second partition wall layer may be 2,000 Å or more.

A quantity of sub-layers comprised in the second partition wall layer may range from two to ten.

A thickness of each of the plurality of sub-layers may range from 200 Å to 1,000 Å.

The plurality of sub-layers may include a first sub-layer, a second sub-layer, a third sub-layer, and a fourth sub-layer sequentially arranged in a thickness direction of the base layer, and grains of a sub-layer included among the first sub-layer, the second sub-layer, the third sub-layer, and the fourth sub-layer may be distinguished from grains of another sub-layer which is included among the first sub-layer, the second sub-layer, the third sub-layer, and the fourth sub-layer and adjacent the sub-layer.

The first sub-layer and the third sub-layer may include titanium (Ti), and the second sub-layer and the fourth sub-later may include a titanium nitride (TiN).

A thickness of each of the first sub-layer, the second sub-layer, the third sub-layer, and the fourth sub-layer may range from 400 Å to 600 Å.

The plurality of sub-layers may include a first sub-layer disposed on the first partition wall layer, a second sub-layer disposed on the first sub-layer, and a third sub-layer disposed on the second sub-layer, and grains of a sub-layer included among the first sub-layer, the second sub-layer, and the third sub-layer may be distinguished from grains of another sub-layer which is included among the first sub-layer, the second sub-layer, and the third sub-layer and adjacent the sub-layer.

A thickness of each of the first sub-layer, the second sub-layer, and the third sub-layer may range from 600 Å to 800 Å.

According to an embodiment, a method of manufacturing a display panel includes providing a preliminary display panel including a base layer and a pixel defining film disposed on the base layer, forming a first preliminary partition wall layer on the preliminary display panel, forming a second preliminary partition wall layer including a plurality of preliminary sub-layers on the first preliminary partition wall layer, forming a first partition wall layer and a second partition wall layer including a plurality of sub-layers by etching the first preliminary partition wall layer and the second preliminary partition wall layer, and forming a light emitting pattern and a cathode. The forming of the first partition wall layer and the second partition wall layer includes forming a partition wall opening, the partition wall opening includes a first area defined by an inner surface of the first partition wall layer and a second area defined by an inner surface of the second partition wall layer, and a width of the first area in a direction is greater than a width of the second area in the direction.

The forming of the second preliminary partition wall layer including the plurality of preliminary sub-layers on the first preliminary partition wall layer may include forming a first preliminary sub-layer on the first preliminary partition wall layer inside a chamber, changing temperatures or contact gaseous environments of the preliminary display panel, the first preliminary partition wall layer, and the first preliminary sub-layer, and forming a second preliminary sub-layer on the first preliminary sub-layer inside the chamber.

The changing of the temperatures or the contact gaseous environments of the preliminary display panel, the first preliminary partition wall layer, and the first preliminary sub-layer may include moving the preliminary display panel, the first preliminary partition wall layer, and the first preliminary sub-layer arranged inside the chamber to outside of the chamber.

The forming of the second preliminary partition wall layer including the plurality of preliminary sub-layers on the first preliminary partition wall layer may include depositing preliminary sub-layers having a thickness ranging from 200 Å to 1,000 Å, wherein a quantity of the preliminary sub-layers may range from two to ten, and each of the plurality of preliminary sub-layers may include titanium (Ti) or a titanium nitride (TiN).

The forming of the second preliminary partition wall layer including the plurality of preliminary sub-layers on the first preliminary partition wall layer may include depositing a first preliminary sub-layer having a thickness ranging from 400 Å to 600 Å on the first preliminary partition wall layer, depositing a second preliminary sub-layer having a thickness ranging from 400 Å to 600 Å on the first preliminary sub-layer, depositing a third preliminary sub-layer having a thickness ranging from 400 Å to 600 Å on the second preliminary sub-layer, and depositing a fourth preliminary sub-layer having a thickness ranging from 400 Å to 600 Å on the third preliminary sub-layer.

The first preliminary sub-layer and the third preliminary sub-layer may include titanium (Ti), and the second preliminary sub-layer and the fourth preliminary sub-layer may include a titanium nitride (TiN).

The forming of the second preliminary partition wall layer including the plurality of preliminary sub-layers on the first preliminary partition wall layer may include depositing a first preliminary sub-layer having a thickness ranging from 600 Å to 800 Å on the first preliminary partition wall layer, depositing a second preliminary sub-layer having a thickness ranging from 600 Å to 800 Å on the first preliminary sub-layer, and depositing a third preliminary sub-layer having a thickness ranging from 600 Å to 800 Å on the second preliminary sub-layer.

According to an embodiment, a display panel includes a base layer, a pixel defining film disposed on the base layer and having a light emitting opening, a partition wall including a first partition wall layer disposed on the pixel defining film and a second partition wall layer disposed on the first partition wall layer and having a partition wall opening overlapping the light emitting opening, and a light emitting element including an anode, an intermediate layer, and a cathode, wherein the cathode is in contact with the partition wall and disposed inside the light emitting opening and the partition wall opening, and the second partition wall layer includes a plurality of sub-layers, and an average roughness of each of the plurality of sub-layers is 1 nm or less.

Each of the plurality of sub-layers may include titanium (Ti) or a titanium nitride (TiN), and a thickness of each of the plurality of sub-layers may range from 200 Å to 1,000 Å.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1A is a perspective view of an electronic device according to an embodiment of the present disclosure.
FIG. 1B is an exploded perspective view of the electronic device according to an embodiment of the present disclosure.
FIG. 2 is a cross-sectional view of a display module according to an embodiment of the present disclosure.
FIG. 3 is a plan view of a display panel according to an embodiment of the present disclosure.
FIG. 4 is an enlarged plan view of a portion of a display area of the display panel according to an embodiment of the present disclosure.
FIG. 5 is a cross-sectional view of the display panel along line I-I' of FIG. 3.
FIG. 6A is a cross-sectional view of the display panel along line I-I' of FIG. 3.
FIG. 6B is a transmission electron microscope (TEM) picture obtained by photographing a portion corresponding to a second partition wall layer of FIG. 6A.
FIGS. 7A to 7O are cross-sectional views illustrating some of operations of a method for manufacturing a display panel according to an embodiment of the present disclosure.

### DETAILED DESCRIPTION

In the specification, the expression that a first component (or area, layer, part, portion, or the like) is "disposed on", "connected with" or "coupled to" a second component means that the first component is directly disposed on/connected with/coupled to the second component or means that a third component is interposed therebetween.

The same reference numerals refer to the same components. Further, in the drawings, the thickness, the ratio, and the dimension of components are exaggerated for effective description of technical contents. The expression "and/or" includes one or more combinations which associated components are capable of defining.

Although the terms "first", "second", and the like may be used to describe various components, the components should not be limited by the terms. The terms are used to distinguish one component from another component. For example, without departing from the right scope of the present disclosure, a first component may be referred to as a second component, and similarly, the second component may be also referred to as the first component. Singular expressions include plural expressions unless clearly otherwise indicated in the context.

The terms "under", "below", "on", "above", and the like are used to describe the correlation of components illustrated in drawings. The terms that are relative in concept are described based on a direction illustrated in drawings.

It will be understood that the terms "include", "comprise", "have", and the like specify the presence of features, numbers, steps, operations, elements, or components, described in the specification, or a combination thereof, and do not exclude in advance the presence or additional possibility of one or more other features, numbers, steps, operations, elements, or components or a combination thereof.

The terms "about" or "approximately" as used herein are inclusive of the stated value and include a suitable range of deviation for the particular value as determined by one of ordinary skill in the art, considering the measurement in question and the error associated with measurement of the particular quantity. The terms "about" or "approximately" can mean within one or more standard deviations, or within ± 30%, 20%, 10%, 5% of the stated value, for example.

The term "substantially," as used herein, means approximately or actually. The term "substantially equal" means approximately or actually equal. The term "substantially the same" means approximately or actually the same. The term "substantially perpendicular" means approximately or actually perpendicular. The term "substantially parallel" means approximately or actually parallel. The term "substantially aligned" means approximately or actually aligned.

Unless otherwise defined, all terms (including technical terms and scientific terms) used in the specification have the same meaning as commonly understood by those skilled in the art to which the present disclosure belongs. Further, terms such as terms defined in the dictionaries commonly used should be interpreted as having a meaning consistent with the meaning in the context of the related technology and should not be interpreted in overly ideal or overly formal meanings unless explicitly defined herein.

Hereinafter, an embodiment of the present disclosure will be described with reference to the accompanying drawings.

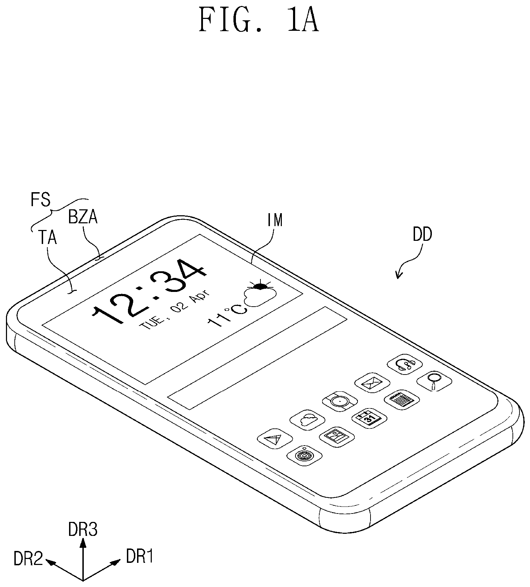

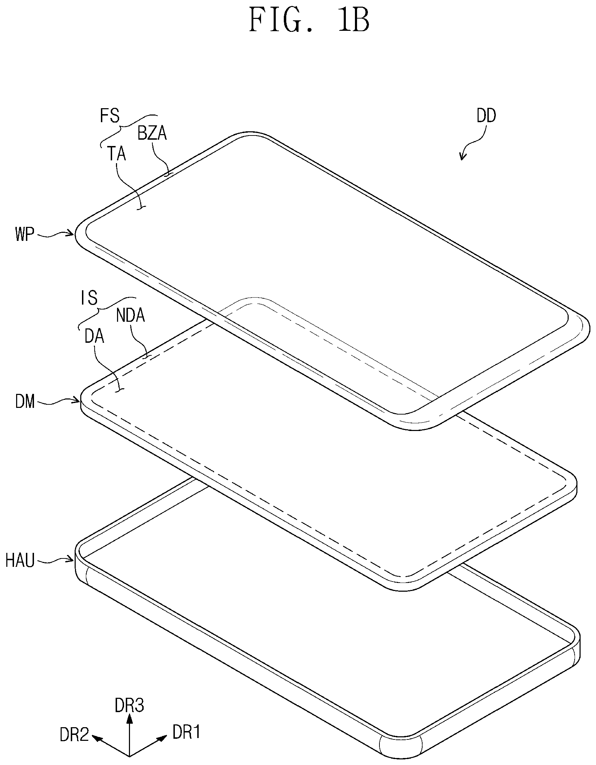

FIG. 1A is a perspective view of an electronic device DD according to an embodiment of the present disclosure, and FIG. 1B is an exploded perspective view of the electronic device DD according to an embodiment of the present disclosure.

In an embodiment, the electronic device DD may be a large-sized electronic device such as, for example, a television, a monitor, or an external billboard. Further, the electronic device DD may be a small or medium-sized electronic device such as, for example, a personal computer (PC), a laptop, a personal digital terminal, a vehicle navigation unit, a game console, a smart phone, a tablet PC, and a camera. However, this is illustrative, and other electronic devices may be adopted as long as the electronic devices do not deviate from the concept of the present disclosure. In the example illustrated in FIGS. 1A and 1B, the electronic device DD is a smart phone.

Referring to FIGS. 1A and 1B, the electronic device DD may display an image IM in a third direction DR3 on a display surface FS parallel to a first direction DR1 and a second direction DR2. The image IM may include a still image as well as a dynamic image. In FIG. 1A, a watch window and icons are illustrated as an example of the image IM. The display surface FS on which the image IM is displayed may correspond to a front surface of the electronic device DD.

In an embodiment, a front surface (or an upper surface) and a rear surface (or a lower surface) of each member are defined with respect to a direction, in which the image IM is displayed. The front surface and the rear surface may face each other in the third direction DR3, and a normal direction of each of the front surface and the rear surface may be parallel to the third direction DR3. Directions indicated by the first to third directions DR1, DR2, and DR3 are relative concepts and may be changed to other directions. In the specification, a phrase of "on a plane" may mean a state when viewed in the third direction DR3.

The electronic device DD may include a window WP, a display module DM, and a housing HAU. The window WP and the housing HAU may be coupled to each other to constitute an exterior of the electronic device DD.

The window WP may include an optically transparent insulating material. For example, the window WP may include a glass or plastic. A front surface of the window WP may define the display surface FS of the electronic device DD. The display surface FS may include a transmissive area TA and a bezel area BZA. The transmissive area TA may be an optically transparent area. For example, the transmissive area TA may be an area having a visible light transmittance of about 90% or more.

The bezel area BZA may be an area having a relatively lower light transmittance than a light transmittance of the transmissive area TA. The bezel area BZA may define a shape of the transmissive area TA. The bezel area BZA may be adjacent to the transmissive area TA and surround the transmissive area TA. However, this is illustrative, and the bezel area BZA of the window WP may be omitted. The window WP may include at least one functional layer of a fingerprint preventing layer, a hard coating layer, and a reflection preventing layer, and is not limited to an embodiment.

The display module DM may be disposed under the window WP. The display module DM may be a component that substantially generates the image IM. The image IM generated by the display module DM is displayed on a display surface IS of the display module DM and is visually recognized by a user from the outside through the transmissive area TA.

The display module DM may include a display area DA and a non-display area NDA. The display area DA may be an area that is activated according to an electric signal. The non-display area NDA may be adjacent to the display area DA. The non-display area NDA may surround the display area DA. The non-display area NDA is an area covered by the bezel area BZA and may not be visually recognized from the outside.

The housing HAU may be coupled to the window WP. The housing HAU may be coupled to the window WP to provide a predetermined inner space. The display module DM may be accommodated in the inner space.

The housing HAU may include a material having a relatively high rigidity. For example, the housing HAU may include a plurality of frames and/or plates including a glass, a plastic, or a metal or formed of a combination thereof. The housing HAU may stably protect components of the electronic device DD accommodated in the inner space from an external impact.

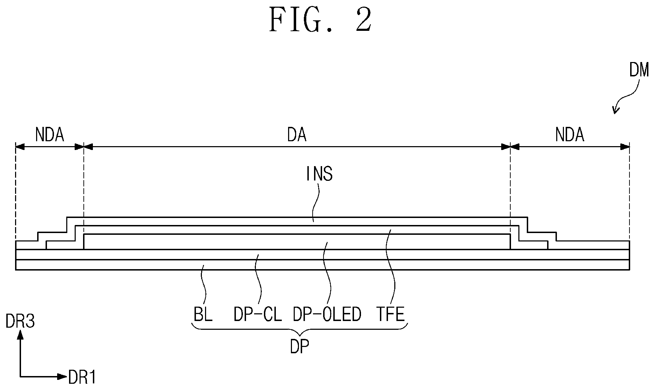

FIG. 2 is a cross-sectional view of the display module DM according to an embodiment of the present disclosure.

Referring to FIG. 2, the display module DM may include a display panel DP and an input sensor INS. Although not separately illustrated, the electronic device DD (see FIG. 1A) according to an embodiment of the present disclosure may further include a protective member disposed on a lower surface of the display panel DP or a reflection preventing member and/or a window member disposed on an upper surface of the input sensor INS.

The display panel DP may be a light emitting display panel. However, this is illustrative, and the present disclosure is not particularly limited thereto. For example, the display panel DP may be an organic light emitting display panel or an inorganic light emitting display panel. A light emitting layer in the organic light emitting display panel may include an organic light emitting material. A light emitting layer in the inorganic light emitting display panel may include a quantum dot, a quantum rod, or a micro light emitting diode (LED). Hereinafter, the display panel DP will be described as the organic light emitting display panel.

The display panel DP may include a base layer BL, and a circuit element layer DP-CL, a display element layer DP-OLED, and a thin film encapsulation layer TFE which are arranged on the base layer BL. The input sensor INS may be directly disposed on the thin film encapsulation layer TFE. In the specification, the wording "component 'A' is directly disposed on component 'B'" means that no adhesive layer is disposed between component 'A' and component 'B'.

The base layer BL may include at least one plastic film. The base layer BL is a flexible substrate and may include a plastic substrate, a glass substrate, a metal substrate, or an organic/inorganic composite material substrate. The display area DA and the non-display area NDA described in FIG. 1B may be equally defined on the base layer BL.

The circuit element layer DP-CL may include at least one insulating layer and a circuit element. The insulating layer includes at least one inorganic layer and at least one organic layer. The circuit element includes signal lines, a driving circuit of a pixel, and the like.

The display element layer DP-OLED may include a partition wall and a light emitting element. The light emitting element may include an anode, an intermediate layer, and a cathode.

The thin film encapsulation layer TFE may include a plurality of thin films. Some thin films may be arranged to improve optical efficiency, and some thin films may be arranged to protect organic light emitting diodes.

The input sensor INS acquires coordinate information of an external input. The input sensor INS may have a multi-layer structure. The input sensor INS may include a single-layered or multi-layered conductive layer. Further, the input sensor INS may include a single-layered or multi-layered insulating layer. The input sensor INS may sense the external input in a capacitive manner. However, this is illustrative, and embodiments of the present disclosure are not limited thereto. For example, in an embodiment, the input sensor INS may sense the external input in an electromagnetic induction manner or a pressure sensing manner. In an embodiment of the present disclosure, the input sensor INS may be omitted.

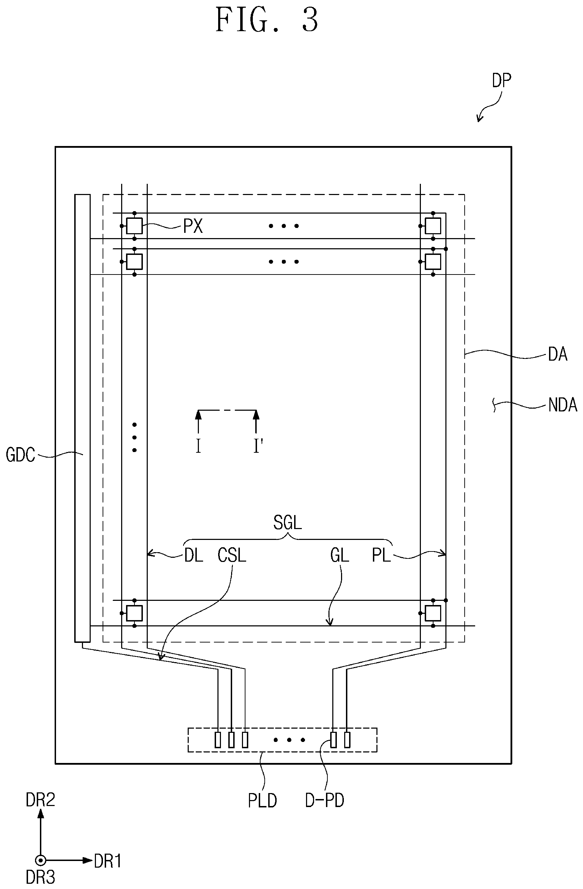

FIG. 3 is a plan view of the display panel DP according to an embodiment of the present disclosure.

Referring to FIG. 3, the display area DA and the non-display area NDA around the display area DA may be defined by the display panel DP. The display panel DP may include pixels PX and signal lines SGL electrically connected to the pixels PX. The display panel DP may include a driving circuit GDC and a pad part PLD. The display area DA and the non-display area NDA may be distinguished from each other depending on whether the pixel PX is disposed. The pixel PX may be disposed in the display area DA. The driving circuit GDC and the pad part PLD may be arranged in the non-display area NDA.

The pixels PX may be arranged in the first direction DR1 and the second direction DR2. The pixels PX may include a plurality of pixel rows extending in the first direction DR1 and arranged in the second direction DR2 and a plurality of pixel columns extending in the second direction DR2 and arranged in the first direction DR1.

The signal lines SGL may include gate lines GL, data lines DL, a power line PL, and a control signal line CSL. Each of the gate lines GL may be connected to a corresponding pixel among the pixels PX, and each of the data lines DL may be connected to a corresponding pixel among the pixels PX. The power line PL may be electrically connected to the pixels PX. The control signal line CSL may be connected to the driving circuit GDC to provide control signals to the driving circuit GDC.

The driving circuit GDC may include a gate driving circuit. The gate driving circuit may generate gate signals and sequentially output the generated gate signals to the gate lines GL. The gate driving circuit may further output another control signal to a pixel driving circuit.

The pad part PLD may be a part to which a flexible circuit board is connected. The pad part PLD may include pixel pads D-PD, and the pixel pads D-PD may be pads for connecting the flexible circuit board to the display panel DP. Each of the pixel pads D-PD may be connected to a corresponding signal line among the signal lines SGL. The pixel pads D-PD may be connected to the corresponding pixels PX through the signal lines SGL. Further, any one pixel pad among the pixel pads D-PD may be connected to the driving circuit GDC.

Further, the pad part PLD may further include input pads. The input pads may be pads for connecting the flexible circuit board to the input sensor INS (see FIG. 2). However, embodiments of the present disclosure are not limited thereto, and the input pads may be arranged in the input sensor INS (see FIG. 2) and connected to the pixel pads D-PD and a separate circuit board. Alternatively, the input sensor INS (see FIG. 2) may be omitted and may not further include the input pads.

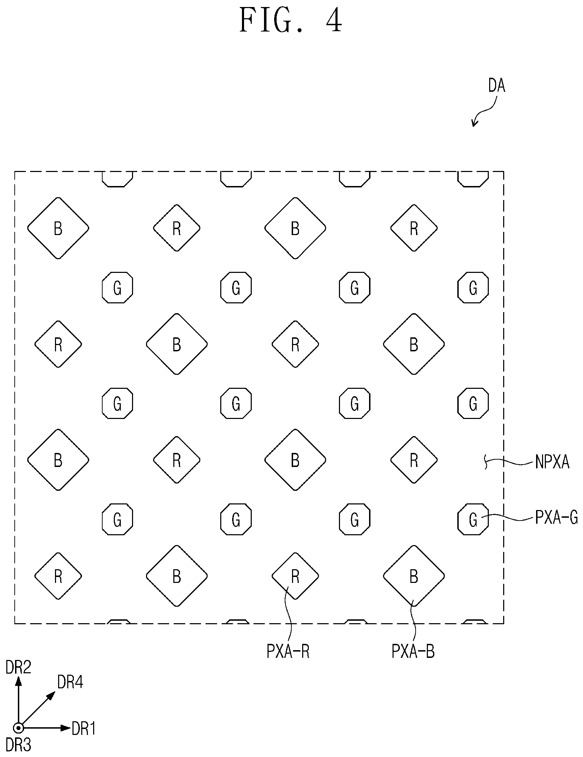

FIG. 4 is an enlarged plan view of a portion of the display area DA of the display panel DP (see FIG. 2) according to an embodiment of the present disclosure. FIG. 4 is a plan view of the display module DM when viewed from the display surface IS (see FIG. 1B) of the display module DM (see FIG. 1B) and illustrates an arrangement of light emitting areas PXA-R, PXA-G, and PXA-B.

Referring to FIG. 4, the display area DA may include the first to third light emitting areas PXA-R, PXA-G, and PXA-B and a peripheral area NPXA surrounding the first to third light emitting areas PXA-R, PXA-G, and PXA-B. The first to third light emitting areas PXA-R, PXA-G, and PXA-B may respectively correspond to areas from which light provided from the light emitting elements is emitted. The first to third light emitting areas PXA-R, PXA-G, and PXA-B may be distinguished according to a color of the light emitted toward the outside of the display module DM (see FIG. 2).

The first to third light emitting areas PXA-R, PXA-G, and PXA-B may provide first to third color light having different colors, respectively. For example, the first color light may be a red light, the second color light may be a green light, and the third color light may be a blue light. However, an example of the first to third color light is not necessarily limited to the above example.

Each of the first to third light emitting areas PXA-R, PXA-G, and PXA-B may be defined as an area in which an upper surface of the anode is exposed by a light emitting opening, which will be described herein. The peripheral area NPXA may set boundaries between the first to third light emitting areas PXA-R, PXA-G, and PXA-B and prevent color mixing between the first to third light emitting areas PXA-R, PXA-G, and PXA-B.

The first to third light emitting areas PXA-R, PXA-G, and PXA-B may be provided such that all of the numbers thereof are plural and may be repeatedly arranged in the display area DA in a specific arrangement form. For example, the first and third light emitting areas PXA-R and PXA-B may be alternately arranged in the first direction DR1 to constitute a "first group." The second light emitting areas PXA-G may be arranged in the first direction DR1 to constitute a "second group." Each of the "first group" and the "second group" may be provided in plurality, and the "first groups" and the "second groups" may be alternately arranged in the second direction DR2.

The one second light emitting area PXA-G may be spaced apart from the one first light emitting area PXA-R or the one third light emitting area PXA-B in a fourth direction DR4. The fourth direction DR4 may be defined as a direction between the first direction DR1 and the second direction DR2.

FIG. 4 illustrates an example of an arrangement form of the first to third light emitting areas PXA-R, PXA-G, and PXA-B, but embodiments of the present disclosure are not limited thereto, and the first to third light emitting areas PXA-R, PXA-G, and PXA-B may be arranged in various forms. In an embodiment, as illustrated in FIG. 4, the first to third light emitting areas PXA-R, PXA-G, and PXA-B may have a PENTILE^{™} arrangement form. Alternatively, the first to third light emitting areas PXA-R, PXA-G, and PXA-B may also have a stripe arrangement form or a diamond pixel^{™} arrangement form.

The first to third light emitting areas PXA-R, PXA-G, and PXA-B may have various shapes on a plane. For example, the first to third light emitting areas PXA-R, PXA-G, and PXA-B may have shapes such as, for example, a polygonal shape, a circular shape, or an elliptic shape. FIG. 4 illustrates an example of the first and third light emitting areas PXA-R and PXA-B having a quadrangular shape (or a diamond shape) and the second light emitting area PXA-G having an octagonal shape on a plane.

The first to third light emitting areas PXA-R, PXA-G, and PXA-B may have the same shape on a plane or may have at least partially different shapes. FIG. 4 illustrates an example of the first and third light emitting areas PXA-R and PXA-B having the same shape and the second light emitting area PXA-G having a shape different from respective shapes of the first and third light emitting areas PXA-R and PXA-B on a plane.

At least some of the first to third light emitting areas PXA-R, PXA-G, and PXA-B may have different areas on a plane. In an embodiment, an area of the first light emitting area PXA-R that emits a red light may be greater than an area of the second light emitting area PXA-G that emits a green light and may be smaller than an area of the third light emitting area PXA-B that emits a blue light. However, a size relationship between the areas of the first to third light emitting areas PXA-R, PXA-G, and PXA-B according to the color of the emitted light is not limited thereto and may be changed depending on a design of the display module DM (see FIG. 2). Further, embodiments of the present disclosure are not limited thereto, and the first to third light emitting areas PXA-R, PXA-G, and PXA-B may also have the same area on a plane.

The shape, the area, the arrangement, and the like of the first to third light emitting areas PXA-R, PXA-G, and PXA-B of the display module DM (see FIG. 2) according to embodiments of the present disclosure may be variously designed according to the color of the emitted light and the size and configuration of the display module DM and are not limited to an embodiment illustrated in FIG. 4.

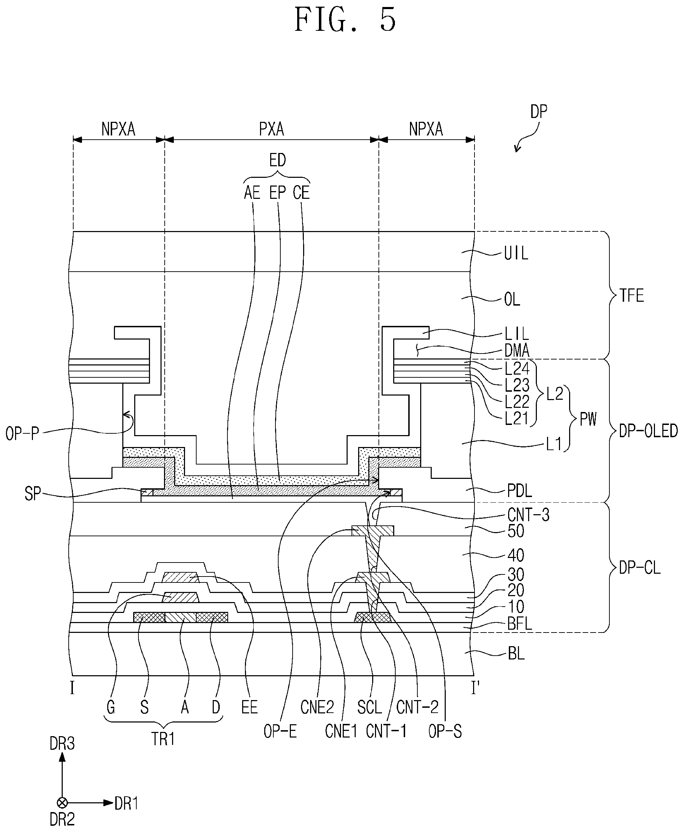

FIG. 5 is a cross-sectional view of the display panel DP along line I-I' of FIG. 3. In description of FIG. 5, the description will be made with reference to FIG. 2, and descriptions for the same reference numerals will be omitted. FIG. 5 is an enlarged view illustrating one light emitting area PXA in the display area DA (see FIG. 4), and the light emitting area PXA of FIG. 5 may correspond to one of the first to third light emitting areas PXA-R, PXA-G, and PXA-B of FIG. 4.

Referring to FIG. 5, the display panel DP may include the base layer BL, the circuit element layer DP-CL, the display element layer DP-OLED, and the thin film encapsulation layer TFE.

The display panel DP may include a plurality of insulating layers, a plurality of semiconductor patterns, a plurality of conductive patterns, a plurality of signal lines, and the like. The insulating layer, the semiconductor layer, and the conductive layer are formed by coating, deposition, or the like. Thereafter, the insulating layer, the semiconductor layer, and the conductive layer may be selectively patterned by photolithography and etching. In this manner, the semiconductor pattern, the conductive pattern, the signal line, and the like included in the circuit element layer DP-CL and the display element layer DP-OLED may be formed.

The circuit element layer DP-CL may be disposed on the base layer BL. The circuit element layer DP-CL may include a buffer layer BFL, a transistor TR1, a signal transmitting area SCL, first to fifth insulating layers 10, 20, 30, 40, and 50, an electrode EE, and a plurality of connection electrodes CNE1 and CNE2.

The buffer layer BFL may be disposed on the base layer BL. The buffer layer BFL may improve a coupling force between the base layer BL and the semiconductor pattern. The buffer layer BFL may include a silicon oxide layer and a silicon nitride layer. The silicon oxide layer and the silicon nitride layer may be alternately disposed.

A semiconductor pattern may be disposed on the buffer layer BFL. The semiconductor pattern may include polysilicon. However, embodiments of the present disclosure are not limited thereto, and the semiconductor pattern may include an amorphous silicon or a metal oxide. FIG. 5 illustrates an example of a portion of the semiconductor pattern, and the semiconductor patterns may be further arranged in the plurality of light emitting areas PXA-R, PXA-G, and PXA-B (see FIG. 4). The semiconductor pattern may be arranged in a specific rule across the plurality of light emitting areas PXA-R, PXA-G, and PXA-B. The semiconductor pattern may have a different electrical property depending on whether or not the semiconductor pattern is doped. The semiconductor pattern may include a first area having a high doping concentration and a second area having a low doping concentration. The first area may be doped with an N-type dopant or a P-type dopant. A P-type transistor may include the first area doped with the P-type dopant.

A conductivity of the first area is greater than a conductivity of the second area, and the first area may substantially serve as an electrode or a signal line. The second area may substantially correspond to an active area (or a channel) of a transistor. In other words, a portion of the semiconductor pattern may be the active area of the transistor, another portion of the semiconductor pattern may be a source area or a drain area of the transistor, and still another portion of the semiconductor pattern may be a conductive area.

A source area "S," an active area "A," and a drain area "D" of the transistor TR1 may be formed from the semiconductor pattern. FIG. 5 illustrates a portion of the signal transmitting area SCL formed from the semiconductor pattern. Although not separately illustrated, the signal transmitting area SCL may be connected to the drain area "D" of the transistor TR1 on a plane.

The first to fifth insulating layers 10, 20, 30, 40, and 50 may be arranged on the buffer layer BFL. The first to fifth insulating layers 10, 20, 30, 40, and 50 may be inorganic layers or organic layers.

The first insulating layer 10 may be disposed on the buffer layer BFL. The first insulating layer 10 may cover the source area "S," the active area "A," and the drain area "D" of the transistor TR1 disposed on the buffer layer BFL, and the signal transmitting area SCL. A gate "G" of the transistor TR1 may be disposed on the first insulating layer 10. The second insulating layer 20 may be disposed on the first insulating layer 10 and cover the gate "G." The electrode EE may be disposed on the second insulating layer 20. The third insulating layer 30 may be disposed on the second insulating layer 20 and cover the electrode EE.

The first connection electrode CNE1 may be disposed on the third insulating layer 30. The first connection electrode CNE1 may be connected to the signal transmitting area SCL through a contact hole CNT-1 passing through the first to third insulating layers 10, 20, and 30. The fourth insulating layer 40 may be disposed on the third insulating layer 30 and cover the first connection electrode CNE1. The fourth insulating layer 40 may be an organic layer.

The second connection electrode CNE2 may be disposed on the fourth insulating layer 40. The second connection electrode CNE2 may be connected to the first connection electrode CNE1 through a contact hole CNT-2 passing through the fourth insulating layer 40. The fifth insulating layer 50 may be disposed on the fourth insulating layer 40 and cover the second connection electrode CNE2. The fifth insulating layer 50 may be an organic layer.

The display element layer DP-OLED may be disposed on the circuit element layer DP-CL. The display element layer DP-OLED may include a light emitting element ED, a sacrificial pattern SP, a pixel defining film PDL, and a partition wall PW.

The light emitting element ED may include an anode AE (or a first electrode), a light emitting pattern EP, and a cathode CE (or a second electrode). The light emitting element ED may be disposed inside a light emitting opening OP-E and a partition wall opening OP-P, which will be described herein.

The anode AE may be disposed on the fifth insulating layer 50 of the circuit element layer DP-CL. The anode AE may be a transmissive electrode, a semi-transmissive electrode, or a reflective electrode. The anode AE may be connected to the second connection electrode CNE2 through a connection contact hole CNT-3 defined through the fifth insulating layer 50. Thus, the anode AE may be electrically connected to the signal transmitting area SCL through the first connection electrode CNE1 and the second connection electrode CNE2 and thus electrically connected to the corresponding circuit element. The anode AE may include a single-layer structure or a multi-layer structure. The anode AE may include a plurality of layers including ITO and Ag. For example, the anode AE may include a layer including the ITO (hereinafter, referred to as a lower ITO layer), a layer disposed on the lower ITO layer and including Ag (hereinafter, referred to as an Ag layer), and a layer disposed on the Ag layer and including the ITO (hereinafter, referred to as an upper ITO layer).

The sacrificial pattern SP may be disposed between the anode AE and the pixel defining film PDL. The sacrificial pattern SP may define (or have) a sacrificial opening OP-S through which a portion of an upper surface of the anode AE is exposed. The sacrificial opening OP-S may overlap the light emitting opening OP-E, which will be described herein.

The pixel defining film PDL may be disposed on the fifth insulating layer 50 of the circuit element layer DP-CL. The pixel defining film PDL may define (or have) the light emitting opening OP-E. The light emitting opening OP-E may correspond to the anode AE, and the pixel defining film PDL may expose at least a portion of the anode AE through the light emitting opening OP-E.

Further, the light emitting opening OP-E may correspond to the sacrificial opening OP-S of the sacrificial pattern SP. According to an embodiment, the upper surface of the anode AE may be spaced apart from the pixel defining film PDL on a cross section with the sacrificial pattern SP interposed between the upper surface of the anode AE and the pixel defining film PDL, and accordingly, damage to the anode AE may be prevented or minimized in a process of forming the light emitting opening OP-E.

On a plane, an area of the light emitting opening OP-E may be smaller than an area of the sacrificial opening OP-S. That is, an inner surface of the pixel defining film PDL defining the light emitting opening OP-E may be closer to a center of the anode AE than an inner surface of the sacrificial pattern SP defining the sacrificial opening OP-S. However, embodiments of the present disclosure are not limited thereto, and the inner surface of the sacrificial pattern SP defining the sacrificial opening OP-S may be substantially aligned with the inner surface of the pixel defining film PDL defining the light emitting opening OP-E. In this case, the light emitting area PXA may be regarded as an area of the anode AE exposed from the corresponding sacrificial opening OP-S.

The pixel defining film PDL may include an inorganic insulating material. For example, the pixel defining film PDL may include a silicon nitride (SiNₓ). The pixel defining film PDL may be disposed between the anode AE and the partition wall PW and block electrical connection between the anode AE and the partition wall PW.

The light emitting pattern EP may be disposed on the anode AE. The light emitting pattern EP may include a light emitting layer including a light emitting material. The light emitting pattern EP may further include a hole injection layer (HIL) and a hole transport layer (HTL) arranged between the anode AE and the light emitting layer and may further include an electron transport layer (ETL) and an electron injection layer (EIL) arranged on the light emitting layer. The light emitting pattern EP may be referred to as an "organic layer" or an "intermediate layer."

The light emitting pattern EP may be patterned by a tip portion defined by the partition wall PW. Details will be described herein in description of a method of manufacturing the display panel. The light emitting pattern EP may be disposed inside the sacrificial opening OP-S and the light emitting opening OP-E. However, this is illustratively illustrated, and the light emitting pattern EP may be disposed inside at least one of the sacrificial opening OP-S, the light emitting opening OP-E, and the partition wall opening OP-P. The light emitting pattern EP may cover a portion of an upper surface of the pixel defining film PDL.

The cathode CE may be disposed on the light emitting pattern EP. The cathode CE may be patterned by the tip portion defined by the partition wall PW. At least a portion of the cathode CE may be disposed in the partition wall opening OP-P. FIG. 5 illustrates an example that the cathode CE is disposed inside the light emitting opening OP-E and the partition wall opening OP-P, but embodiments of the present disclosure are not limited thereto. For example, the cathode CE may be disposed only inside the partition wall opening OP-P.

A distal end of the cathode CE may be in contact with the partition wall PW. FIG. 5 illustrates an example that only the distal end of the cathode CE is in contact with the partition wall PW, but a deposition angle of a deposition process of forming the cathode CE may be adjusted such that the cathode CE as formed extends in contact with an inner surface of the partition wall PW.

The cathode CE may be conductive. The cathode CE may be formed of various materials such as, for example, a metal, a transparent conductive oxide (TCO), and a conductive polymer material as long as the materials may be conductive. For example, the cathode CE may include silver (Ag), magnesium (Mg), lead (Pb), copper (Cu), or compounds thereof.

The partition wall PW may be disposed on the pixel defining film PDL. The partition wall PW including a conductive material may receive a driving voltage, and accordingly, the cathode CE may be electrically connected to the partition wall PW to receive the driving voltage.

The partition wall PW include a plurality of layers sequentially disposed. For example, the partition wall PW includes a first partition wall layer L1 and a second partition wall layer L2. The first partition wall layer L1 is disposed on the pixel defining film PDL, and the second partition wall layer L2 is disposed on the first partition wall layer L1. As illustrated in FIG. 5, a thickness of the first partition wall layer L1 may be greater than a thickness of the second partition wall layer L2, but embodiments of the present disclosure are not limited thereto.

The first partition wall layer L1 and the second partition wall layer L2 may include a conductive material. For example, the conductive material may include a metal, a TCO, or a combination thereof. For example, the metal may include gold (Au), silver (Ag), aluminium (Al), magnesium (Mg), lithium (Li), molybdenum (Mo), titanium (Ti), copper (Cu), tungsten (W), or an alloy thereof. The TCO may include an indium tin oxide (ITO), an indium zinc oxide (IZO), a zinc oxide, an indium oxide, an indium gallium oxide, an indium gallium zinc oxide (IGZO) or an aluminium zinc oxide. The materials of the first partition wall layer L1 and the second partition wall layer L2 are illustrative and are not limited to the above examples.

The partition wall PW may have an undercut shape on a cross section. At least one of the plurality of layers of the partition wall PW may be recessed as compared to the other layers, and accordingly, the partition wall PW may include the tip portion. For example, the first partition wall layer L1 may have an undercut shape with respect to the second partition wall layer L2. The second partition wall layer L2 may protrude toward the light emitting opening OP-E further than the first partition wall layer L1 to form the tip portion. A portion of the second partition wall layer L2, which protrudes from the first partition wall layer L1 toward the light emitting area PXA, may be defined as the tip portion inside the partition wall PW. That is, an inner surface of the second partition wall layer L2 may be closer to a center of the anode AE than an inner surface of the first partition wall layer L1.

The partition wall opening OP-P may be defined in the partition wall PW. The partition wall opening OP-P may overlap the light emitting opening OP-E. The partition wall opening OP-P of the partition wall PW may include a first area A1 and a second area A2. The first area A1 may be defined by the inner surface of the first partition wall layer L1, and the second area A2 may be defined by the inner surface of the second partition wall layer L2. A width of the first area A1 in a direction (e.g., the first direction DR1 or the second direction DR2) may be greater than a width of the second area A2 in the direction (e.g., the first direction DR1 or the second direction DR2).

The second partition wall layer L2 may have a thickness of 2000 Å or more. The thickness of the second partition wall layer L2 may have an upper limit of 5000 Å. Accordingly, a portion of the second partition wall layer L2, which forms the tip portion, may maintain a robust shape, and thereafter, the light emitting pattern EP and the cathode CE may be normally formed through a patterning process using the tip portion.

The second partition wall layer L2 may include a plurality of sub-layers L21, L22, L23, and L24 that are repeatedly disposed (i.e., formed on the second partition wall layer L2). Expressed another way, the second partition wall layer L2 may be laminated with the plurality of sub-layers L21, L22, L23, and L24. An average roughness of each of the plurality of sub-layers L21, L22, L23, and L24 may be smaller than or equal to 1 nm. The roughness may be a property of a material that represents a roughness of a surface of the material. The roughness may be measured by calculating the RMS value using Atomic Force Microscopy.

The plurality of sub-layers L21, L22, L23, and L24 may include the first sub-layer L21, the second sub-layer L22, the third sub-layer L23, and the fourth sub-layer L24. The first to fourth sub-layers L21, L22, L23, and L24 may be sequentially arranged in a thickness direction (e.g., the third direction DR3) of the base layer. For example, the first sub-layer L21 may be disposed on the first partition wall layer L1, the second sub-layer L22 may be disposed on the first sub-layer L21, the third sub-layer L23 may be disposed on the second sub-layer L22, and the fourth sub-layer L24 may be disposed on the third sub-layer L23.

Grains constituting each of the first to fourth sub-layers L21, L22, L23, and L24 may be distinguished from grains of sub-layers respectively adjacent to the first to fourth sub-layers L21, L22, L23, and L24. In some examples, descriptions of grains being distinguished from one another may refer to grains which differ from each other based on size, quantity, arrangement, or the like of the grains. For example, the grains constituting the second sub-layer L22 may be distinguished from the grains of the first and third sub-layers L21 and L23, and the grains constituting the third sub-layer L23 may be distinguished from the grains of the second and fourth sub-layers L22 and L24.

In an embodiment of the present disclosure, each of the plurality of sub-layers L21, L22, L23, and L24 may include titanium (Ti) or a titanium nitride (TiN). For example, the first to fourth sub-layers L21, L22, L23, and L24 may be formed of the same material including titanium (Ti) or may be formed of the same material including a titanium nitride (TiN). However, this is illustrative, and among the first to fourth sub-layers L21, L22, L23, and L24, the first and third sub-layers L21 and L23 may include titanium (Ti), and the second and fourth sub-layers L22 and L24 may include a titanium nitride (TiN).

A thickness of each of the plurality of sub-layers L21, L22, L23, and L24 may be 200 Å or more and 1000 Å or less. In particular, when the plurality of sub-layers L21, L22, L23, and L24 include the first to fourth sub-layers L21, L22, L23, and L24, a thickness of each of the first to fourth sub-layers L21, L22, L23, and L24 may range from 400 Å to 600 Å. For example, the thickness of each of the first to fourth sub-layers L21, L22, L23, and L24 may be 500 Å.

FIG. 5 illustrates the second partition wall layer L2 including the four sub-layers, but this is illustrative, and the present disclosure is not limited to the example. The second partition wall layer L2 includes sub-layers, and a quantity of the sub-layers may range from two to ten. Further, FIG. 5 illustrates an example that the inner surface of the partition wall PW is perpendicular to the upper surface of the pixel defining film PDL, but embodiments of the present disclosure are not limited thereto. For example, the partition wall PW may have a tapered shape or a reverse tapered shape.

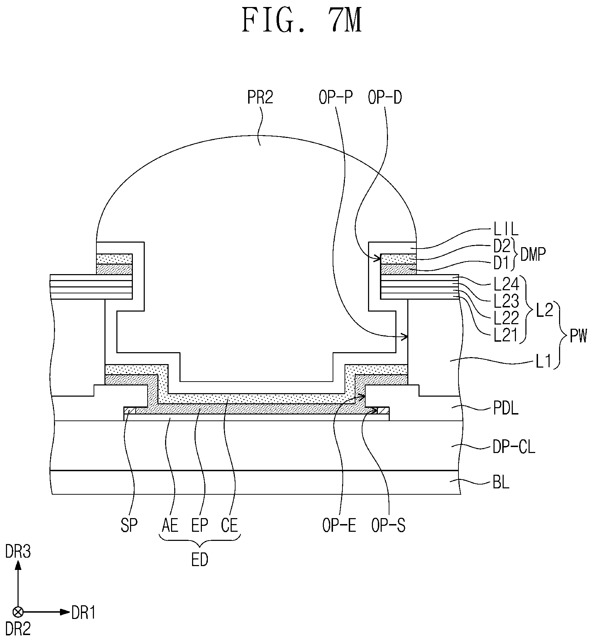

A dummy area DMA may be formed on the partition wall PW. In detail, the dummy area DMA may be formed between the partition wall PW and a lower encapsulation inorganic pattern LIL on a cross section. The dummy area DMA may be defined as an area in which dummy patterns DMP (see FIG. 7M) are formed and then removed during a process of manufacturing a display panel, which will be described herein.

According to the present disclosure, the plurality of light emitting patterns EP may be patterned and deposited in units of pixels by the tip portion defined in the partition wall PW. That is, the light emitting patterns EP may be commonly formed using an open mask, but may be easily divided in units of pixels by the partition wall PW.

In some examples that are not embodiments of the present invention, a support spacer protruding from a conductive partition wall may be provided to support a fine metal mask (FMM) when the light emitting patterns EP are patterned using the FMM. Further, since the FMM is spaced a height of the partition wall PW and the spacer from a base surface, on which the patterning is performed, implementation in a high resolution may be limited. Further, as the FMM comes into contact with the spacer, foreign substances may remain in the spacer after a process of patterning the light emitting patterns EP or the spacer may be damaged by stabbing of the FMM. Accordingly, a defective display panel may be formed.

According to an embodiment, the partition wall PW is included, and thus the light emitting elements ED may be physically and easily separated from each other. Accordingly, a current leakage or a driving error between the adjacent light emitting areas PXA-R, PXA-G, and PXA-B may be prevented, and the light emitting elements ED may be driven independently of each other.

In particular, the light emitting patterns EP are patterned without a mask in contact with an internal component inside the display area DA (see FIG. 1B), and thus the display panel DP having improved process reliability due to a reduced defect rate may be provided. As the patterning may be performed even when the separate support spacer protruding from the partition wall PW is not provided, areas of the light emitting areas PXA-R, PXA-G, and PXA-B may be miniaturized, and thus the display panel DP that easily implements a high resolution may be provided.

Further, in manufacturing a large-area display panel DP, the display panel DP may be provided in which process costs may be reduced as production of a large-area mask is omitted, and process reliability may be improved as the display panel DP is not affected by defects that may occur in the large-area mask. The description of the light emitting patterns EP may be equally applied to the plurality of light emitting patterns EP corresponding to the light emitting areas PXA-R, PXA-G, and PXA-B.

The thin film encapsulation layer TFE may be disposed on the display element layer DP-OLED. The thin film encapsulation layer TFE may include the lower encapsulation inorganic pattern LIL, an encapsulation organic film OL, and an upper encapsulation inorganic film UIL.

The lower encapsulation inorganic pattern LIL may correspond to the light emitting opening OP-E. The lower encapsulation inorganic pattern LIL may be disposed on the cathode CE. In detail, a portion of the lower encapsulation inorganic pattern LIL may be formed inside the partition wall opening OP-P, and the other portion of the lower encapsulation inorganic pattern LIL may be formed on the partition wall PW.

The encapsulation organic film OL may cover the lower encapsulation inorganic pattern LIL and provide a flat upper surface. A portion of the encapsulation organic film OL may fill the dummy area DMA. The upper encapsulation inorganic film UIL may be disposed on the encapsulation organic film OL.

The lower encapsulation inorganic pattern LIL and the upper encapsulation inorganic film UIL may protect the display element layer DP-OLED from moisture/oxygen, and the encapsulation organic film OL may protect the display element layer DP-OLED from foreign substances such as, for example, dust particles.

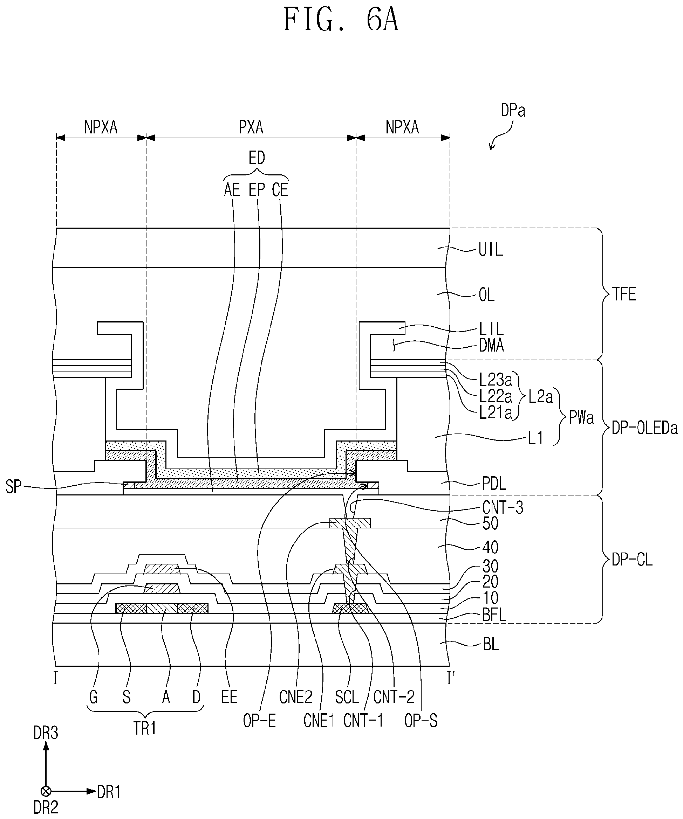

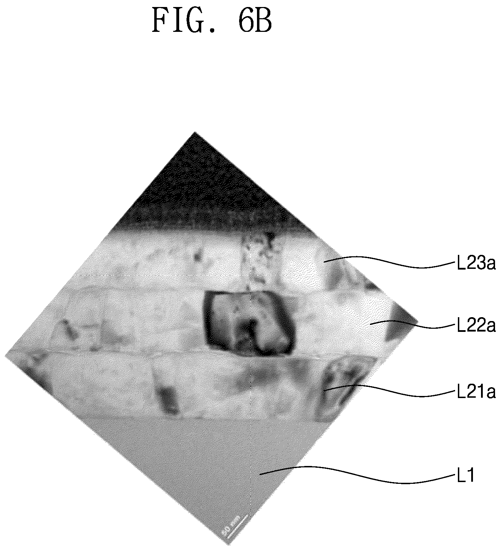

FIG. 6A is a cross-sectional view of a display panel DPa along line I-I' of FIG. 3. FIG. 6B is a transmission electron microscope (TEM) picture obtained by photographing a portion corresponding to a second partition wall layer L2a of FIG. 6A. The description of FIGS. 6A and 6B will be made with reference to FIG. 5, and the descriptions of the same reference numerals will be omitted.

Referring to FIGS. 6A and 6B, the display panel DPa may include the base layer BL, the circuit element layer DP-CL, a display element layer DP-OLEDa, and the thin film encapsulation layer TFE. The display element layer DP-OLEDa may include the light emitting element ED, the sacrificial pattern SP, the pixel defining film PDL, and a partition wall PWa.

The partition wall PWa may include the first partition wall layer L1 and the second partition wall layer L2a, and the second partition wall layer L2a may include a plurality of sub-layers L21a, L22a, and L23a that are repeatedly disposed (i.e., formed on the second partition wall layer L2a). The plurality of sub-layers L21a, L22a, and L23a may include the first sub-layer L21a, the second sub-layer L22a, and the third sub-layer L23a. The first sub-layer L21a may be disposed on the first partition wall layer L1, the second sub-layer L22a may be disposed on the first sub-layer L21a, and the third sub-layer L23a may be disposed on the second sub-layer L22a. Grains constituting each of the first to third sub-layers L21a, L22a, and L23a may be distinguished from grains of sub-layers adjacent thereto. For example, the grains constituting the second sub-layer L22a may be distinguished from the grains of the first and third sub-layers L21a and L23a.

In an embodiment of the present disclosure, the first to third sub-layers L21a, L22a, and L23a may be formed of the same material including titanium (Ti) or may be formed of the same material including a titanium nitride (TiN). However, this is illustrative, and among the first to third sub-layers L21a, L22a, and L23a, the first and third sub-layers L21a and L23a may include titanium (Ti), and the second sub-layer L22a may include a titanium nitride (TiN).

A thickness of each of the plurality of sub-layers L21a, L22a, and L23a may be 200 Å or more and 1000 Å or less. In particular, when the plurality of sub-layers L21a, L22a, and L23a include the first to third sub-layers L21a, L22a, and L23a, a thickness of each of the first to third sub-layers L21a, L22a, and L23a may range from 600 Å to 800 Å. For example, the thickness of each of the first to third sub-layers L21a, L22a, and L23a may be 670 Å.

Referring to FIGS. 5 to 6B, in the present disclosure, the second partition wall layer L2 or L2a may be divided and deposited into the plurality of sub-layers L21, L22, L23, and L24 or L21a, L22a, and L23a, and thus sizes of the grains of the plurality of sub-layers L21, L22, L23, and L24 or L21a, L22a, and L23a may be limited. Accordingly, the sizes of the grains of the sub-layers including titanium (Ti) and gaps between the grains may increase, and generation of a titanium oxide (TiOₓ) formed by introducing an O₂ gas between the grains may be prevented. The second partition wall layer L2 or L2a on which a titanium oxide (TiOₓ) is not formed may be easily etched, and generation of a cone-shaped residue formed due to non-etching of the first partition wall layer L1 may be reduced or removed. Thus, pixel defects in the display panel DP may be reduced or removed.

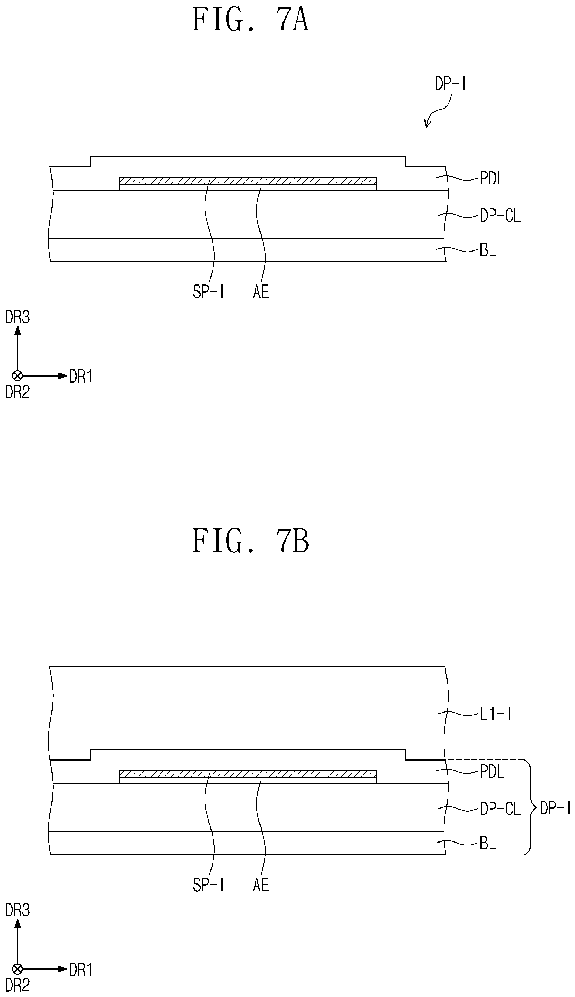

FIGS. 7A to 7O are cross-sectional views illustrating some of operations of a method for manufacturing a display panel according to an embodiment of the present disclosure. In description of FIGS. 7A to 7O, the same/similar components will be described using the same/similar reference numerals with reference to FIGS. 1 to 5, and thus duplicated descriptions will be omitted.

In the descriptions of the method and processes herein, the operations may be performed in a different order than the order shown and/or described, or the operations may be performed in different orders or at different times. Certain operations may also be left out, one or more operations may be repeated, or other operations may be added. Descriptions that an element "may be disposed," "may be formed," and the like include methods, processes, and techniques for disposing, forming, positioning, and modifying the element, and the like in accordance with example aspects described herein.

A method of manufacturing a display panel according to the present disclosure includes an operation of providing a preliminary display panel including a base layer and a pixel defining film disposed on the base layer, an operation of forming a first preliminary partition wall layer on the preliminary display panel, an operation of forming a second preliminary partition wall layer including a plurality of preliminary sub-layers on the first preliminary partition wall layer, an operation of forming a first partition wall layer and a second partition wall layer including a plurality of sub-layers by etching the first preliminary partition wall layer and the second preliminary partition wall layer, and an operation of forming a light emitting pattern and a cathode, wherein the operation of forming the first partition wall layer and the second partition wall layer includes an operation of forming a partition wall opening, the partition wall opening includes a first area defined by an inner surface of the first partition wall layer and a second area defined by an inner surface of the second partition wall layer, and a width of the first area in a direction is greater than a width of the second area in the direction.

Hereinafter, a method of forming the one light emitting element ED and the lower encapsulation inorganic pattern LIL, the encapsulation organic film OL, and the upper encapsulation inorganic film UIL that cover the light emitting element ED will be described through FIGS. 7A to 7O. A display panel formed through FIGS. 7A to 7O may correspond to the display panel DP of FIG. 5.

Referring to FIG. 7A, the method of manufacturing a display panel according to the present disclosure includes an operation of providing a preliminary display panel DP-I. The preliminary display panel DP-I provided in an embodiment may include the base layer BL, the circuit element layer DP-CL, the anode AE, a sacrificial layer SP-I, and the pixel defining film PDL.

The circuit element layer DP-CL may be formed by a general method of manufacturing a circuit element, in which an insulating layer, a semiconductor layer, and a conductive layer are formed through a coating method or a deposition method, the insulating layer, the semiconductor layer, and the conductive layer are selectively patterned by a photolithography and etching process, and a semiconductor pattern, a conductive pattern, a signal line or the like are formed.

The anode AE and the sacrificial layer SP-I may be formed by the same patterning process. The pixel defining film PDL may be disposed on the base layer BL. The pixel defining film PDL may cover both the anode AE and the sacrificial layer SP-I.

Referring to FIG. 7B, the method of manufacturing a display panel according to the present disclosure includes an operation of forming a first preliminary partition wall layer L1-I on the preliminary display panel DP-I. The first preliminary partition wall layer L1-I may be disposed on the pixel defining film PDL.

The first preliminary partition wall layer L1-I may be formed by a process of depositing a conductive material. For example, the conductive material may include a metal, a TCO, or a combination thereof. For example, the metal includes gold (Au), silver (Ag), aluminium (Al), magnesium (Mg), lithium (Li), molybdenum (Mo), titanium (Ti), copper (Cu), or alloys thereof. The TCO may include an indium tin oxide (ITO), an indium zinc oxide (IZO), a zinc oxide, an indium oxide, an indium gallium oxide, an indium gallium zinc oxide (IGZO) or an aluminium zinc oxide. However, the material of the first preliminary partition wall layer L1-I is not limited thereto.

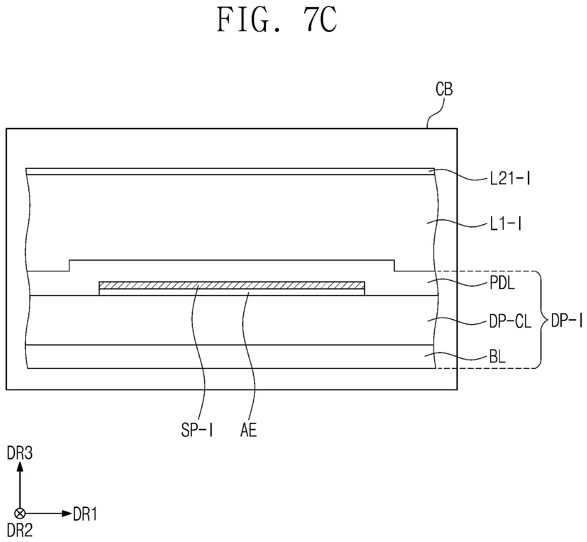

Thereafter, referring to FIGS. 7C to 7F, the method of manufacturing a display panel according to the present disclosure includes an operation of forming a second preliminary partition wall layer L2-I including a plurality of preliminary sub-layers L21-I, L22-I, L23-I, and L24-I on the first preliminary partition wall layer L1-I.

First, referring to FIG. 7C, the operation of forming the second preliminary partition wall layer L2-I including the plurality of preliminary sub-layers L21-I, L22-I, L23-I, and L24-I on the first preliminary partition wall layer L1-I may include an operation of forming the first preliminary sub-layer L21-I on the first preliminary partition wall layer L1-I inside a chamber CB. The first preliminary sub-layer L21-I may be formed by a process of depositing a conductive material. For example, the conductive material may include titanium (Ti) or a titanium nitride (TiN).

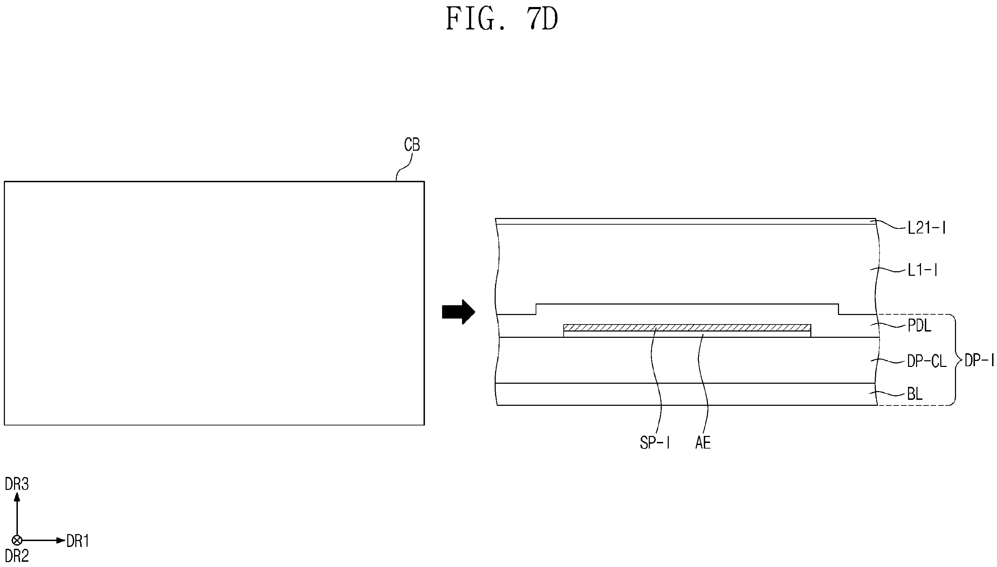

Thereafter, referring to FIG. 7D, the operation of forming the second preliminary partition wall layer L2-I including the plurality of preliminary sub-layers L21-I, L22-I, L23-I, and L24-I on the first preliminary partition wall layer L1-I may include an operation of changing a temperature or a contact gaseous environment of the preliminary display panel DP-I, the first preliminary partition wall layer L1-I, and the first preliminary sub-layer L21-I. In the operation of changing the temperature or the contact gaseous environment of the preliminary display panel DP-I, the first preliminary partition wall layer L1-I, and the first preliminary sub-layer L21-I, growth of the grains constituting the first preliminary sub-layer L21-I may be prevented. As a result, the grains of the second preliminary sub-layer L22-I and the grains of the first preliminary sub-layer L21-I, which will be described herein, may be distinguished from each other.

The operation of changing the temperature or the contact gaseous environment of the preliminary display panel DP-I, the first preliminary partition wall layer L1-I, and the first preliminary sub-layer L21-I may include an operation of moving the preliminary display panel DP-I, the first preliminary partition wall layer L1-I, and the first preliminary sub-layer L21-I arranged inside the chamber CB to the outside of the chamber CB. Alternatively, plasma used to form the first preliminary sub-layer L21-I may be turned off. As a result, a temperature of an upper surface of the first preliminary sub-layer L21-I may decrease, an environment of a gas in contact with the upper surface of the first preliminary sub-layer L21-I may change, and thus the growth of the grains constituting the first preliminary sub-layer L21-I may be prevented.

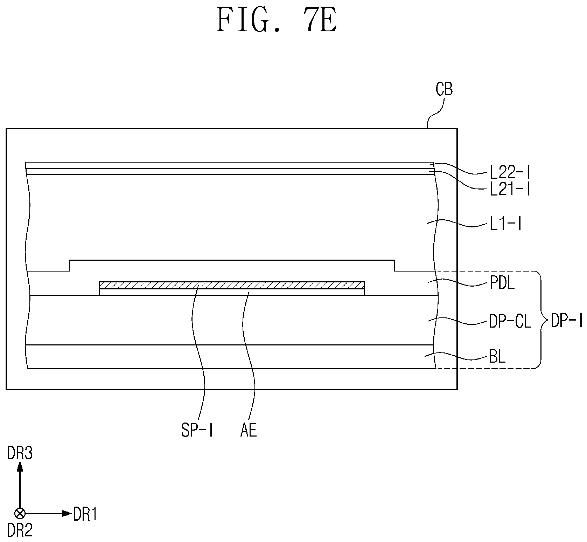

Thereafter, referring to FIG. 7E, the operation of forming the second preliminary partition wall layer L2-I including the plurality of preliminary sub-layers L21-I, L22-I, L23-I, and L24-I on the first preliminary partition wall layer L1-I may include an operation of forming the second preliminary sub-layer L22-I on the first preliminary sub-layer L21-I inside the chamber CB. The second preliminary sub-layer L22-I may be formed by a process of depositing a conductive material. For example, the conductive material may include titanium (Ti) or a titanium nitride (TiN).

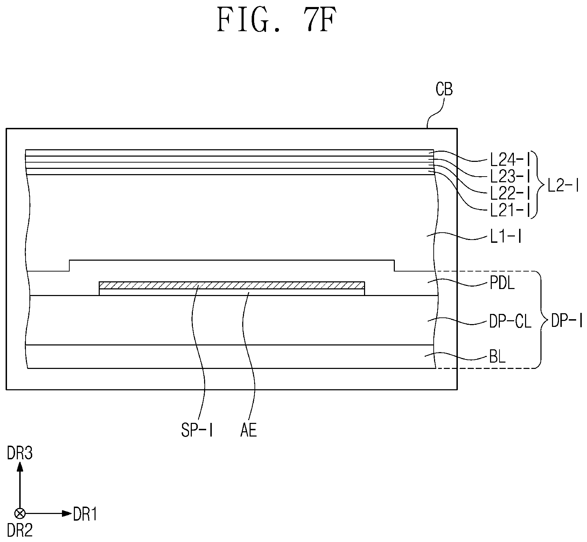

Referring to FIG. 7F, the operation of forming the second preliminary partition wall layer L2-I including the plurality of preliminary sub-layers L21-I, L22-I, L23-I, and L24-I on the first preliminary partition wall layer L1-I may include an operation of forming the third preliminary sub-layer L23-I on the second preliminary sub-layer L22-I and an operation of forming the fourth preliminary sub-layer L24-I on the third preliminary sub-layer L23-I. The operation of forming the third and fourth preliminary sub-layers L23-I and L24-I may be substantially the same as a process described through FIGS. 7C to 7E.

Referring to FIGS. 7C to 7F, the operation of forming the second preliminary partition wall layer L2-I including the plurality of preliminary sub-layers L21-I, L22-I, L23-I, and L24-I on the first preliminary partition wall layer L1-I may include an operation of depositing preliminary sub-layers each having a thickness of 200 Å or more and 1000 Å or less, and a quantity of the preliminary sub-layers may range from two to ten.

In an embodiment of the present disclosure, the method may further include an operation of depositing the first preliminary sub-layer L21-I having a thickness ranging from 400 Å to 600 Å on the first preliminary partition wall layer L1-I, an operation of depositing the second preliminary sub-layer L22-I having a thickness ranging from 400 Å to 600 Å on the first preliminary sub-layer L21-I, an operation of depositing the third preliminary sub-layer L23-I having a thickness ranging from 400 Å to 600 Å on the second preliminary sub-layer L22-I, and an operation of depositing the fourth preliminary sub-layer L24-I having a thickness ranging from 400 Å to 600 Å on the third preliminary sub-layer L23-I. In an embodiment, a thickness of each of the first to fourth preliminary sub-layers L21-I, L22-I, L23-I, and L24-I may be 500 Å.

Each of the plurality of preliminary sub-layers L21-I, L22-I, L23-I, and L24-I may include titanium (Ti) or a titanium nitride (TiN). For example, the first to fourth preliminary sub-layers L21-I, L22-I, L23-I, and L24-I may be formed of the same material including titanium (Ti) or may be formed of the same material including a titanium nitride (TiN). However, this is illustrative, and among the first to fourth preliminary sub-layers L21-I, L22-I, L23-I, and L24-I, the first and third preliminary sub-layers L21-I and L23-I may include titanium (Ti), and the second and fourth preliminary sub-layers L22-I and L24-I may include a titanium nitride (TiN).

In an embodiment of the present disclosure, the method may further include an operation of depositing the first preliminary sub-layer L21-I having a thickness ranging from 600 Å to 800 Å on the first preliminary partition wall layer L1-I, an operation of depositing the second preliminary sub-layer L22-I having a thickness ranging from 600 Å to 800 Å on the first preliminary sub-layer L21-I, and an operation of depositing the third preliminary sub-layer L23-I having a thickness ranging from 600 Å to 800 Å on the second preliminary sub-layer L22-I. In an embodiment, the fourth preliminary sub-layer L24-I may be omitted. In this case, a thickness of each of the first to third preliminary sub-layers L21-I, L22-I, and L23-I may be 670 Å.

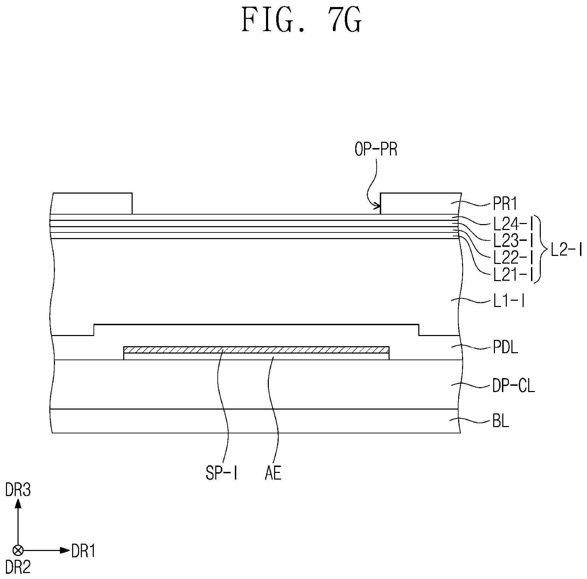

Referring to FIGS. 7G to 7I, the method of manufacturing a display panel according to the present disclosure may further include an operation of forming the first partition wall layer L1 and the second partition wall layer L2 including the plurality of sub-layers L21, L22, L23, and L24 by etching the first preliminary partition wall layer L1-I and the second preliminary partition wall layer L2-I.

As illustrated in FIG. 7G, the method of manufacturing a display panel according to the present disclosure may further include an operation of forming a first photoresist layer PR1 on the second preliminary partition wall layer L2-I. The first photoresist layer PR1 may be formed by forming a preliminary photoresist layer on the second preliminary partition wall layer L2-I and then patterning the preliminary photoresist layer using a photo mask. A photo opening OP-PR may be formed in the first photoresist layer PR1 through the patterning process. The photo opening OP-PR may overlap the anode AE.

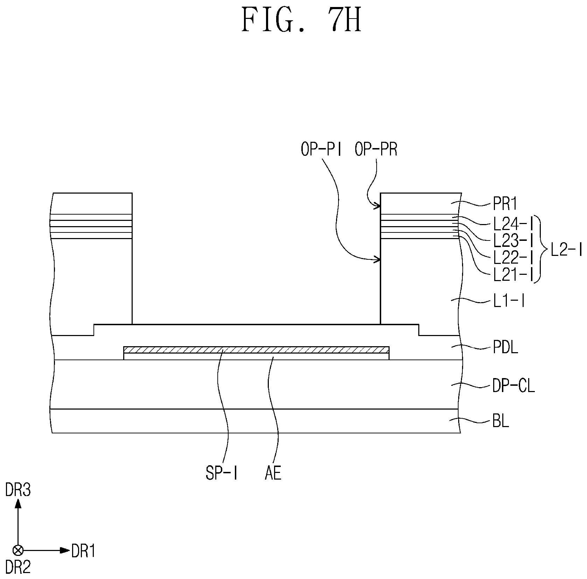

Thereafter, referring to FIG. 7H, the operation of forming the first partition wall layer L1 and the second partition wall layer L2 including the plurality of sub-layers L21, L22, L23, and L24 may include an operation of primarily etching the first preliminary partition wall layer L1-I and the second preliminary partition wall layer L2-I.

In the operation of primarily etching the first preliminary partition wall layer L1-I and the second preliminary partition wall layer L2-I, the first preliminary partition wall layer L1-I and the second preliminary partition wall layer L2-I may be dry-etched using the first photoresist layer PR1 as a mask. Portions of the first preliminary partition wall layer L1-I and the second preliminary partition wall layer L2-I, which do not overlap the first photoresist layer PR1, may be etched and removed. A preliminary partition wall opening OP-PI may be formed in a portion that overlaps the photo opening OP-PR and is removed.

A primary dry etching process in an embodiment may be performed in an etching environment in which an etching selection ratio between the first preliminary partition wall layer L1-I and the second preliminary partition wall layer L2-I is substantially the same. For example, the primary dry etching process may be performed in an etching environment in which an etch rate of the first preliminary partition wall layer L1-I and an etch rate of the second preliminary partition wall layer L2-I are substantially equal. Accordingly, an inner surface of the first preliminary partition wall layer L1-I and an inner surface of the second preliminary partition wall layer L2-I, which define the preliminary partition wall opening OP-PI, may be substantially aligned.

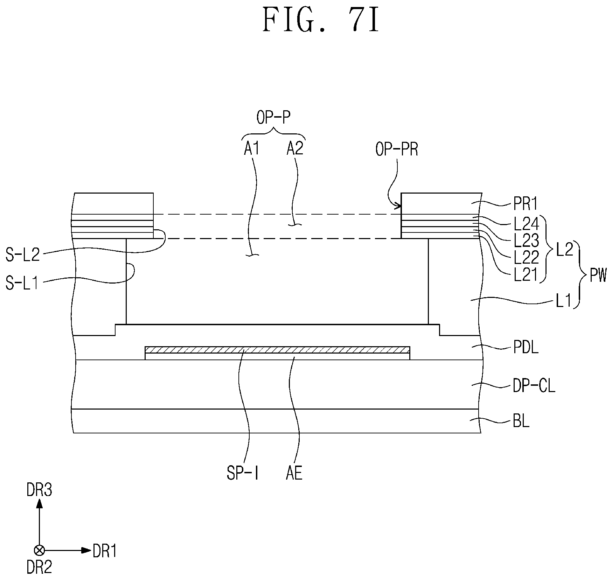

Thereafter, as illustrated in FIG. 7I, the operation of forming the first partition wall layer L1 and the second partition wall layer L2 including the plurality of sub-layers L21, L22, L23, and L24 may include an operation of secondarily etching the first preliminary partition wall layer L1-I. Further, the operation of forming the first partition wall layer L1 and the second partition wall layer L2 may include an operation of forming the partition wall opening OP-P.

In the operation of secondarily etching the first preliminary partition wall layer L1-I, the first preliminary partition wall layer L1-I may be wet-etched using the first photoresist layer PR1 as a mask. Accordingly, a portion of the first preliminary partition wall layer L1-I may be etched to form the partition wall opening OP-P. The partition wall opening OP-P may be formed to overlap the anode AE.

The partition wall opening OP-P of the partition wall PW includes the first area A1 and the second area A2. The first area A1 is defined by the inner surface of the first partition wall layer L1, and the second area A2 is defined by the inner surface of the second partition wall layer L2. A width of the first area A1 in a direction (e.g., a direction perpendicular to the third direction DR3) may be greater than a width of the second area A2 in the direction (e.g., the direction perpendicular to the third direction DR3).

A secondary wet etching process in the present disclosure may be performed in an etching environment in which an etching selection ratio between the first preliminary partition wall layer L1-I (see FIG. 7H) and the second preliminary partition wall layer L2-I (see FIG. 7H) is high. Accordingly, the inner surface of the partition wall PW defining the partition wall opening OP-P may have an undercut shape on a cross section. In detail, an etch rate of the first preliminary partition wall layer L1-I for an etching solution is greater than an etch rate of the second preliminary partition wall layer L2-I for the etching solution, and thus the first preliminary partition wall layer L1-I may be mainly etched. Accordingly, an inner surface S-L1 of the first partition wall layer L1 may be further inwardly recessed as compared to an inner surface S-L2 of the second partition wall layer L2. The tip portion may be formed in the partition wall PW by a portion of the second partition wall layer L2, which protrudes further from the first partition wall layer L1.

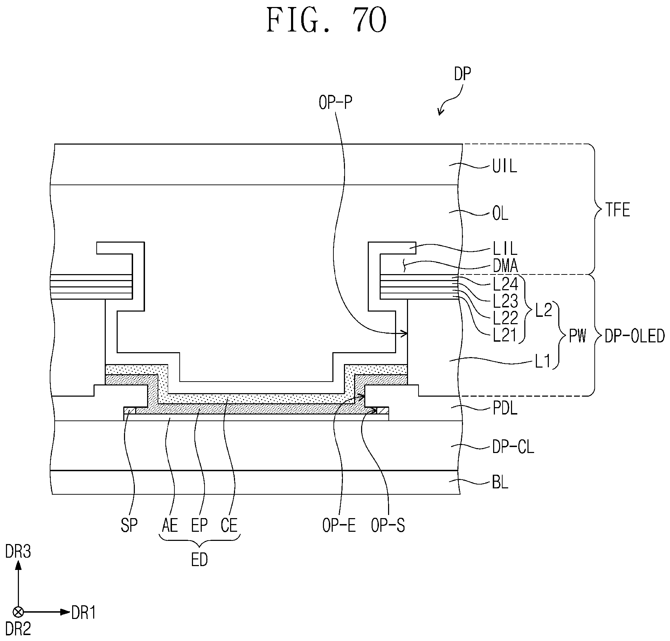

According to the present disclosure, the second preliminary partition wall layer L2-I is divided and deposited into the plurality of preliminary sub-layers L21-I, L22-I, L23-I, and L24-I, and thus the sizes of the grains of the plurality of preliminary sub-layers L21-I, L22-I, L23-I, and L24-I may be limited. Accordingly, the sizes of the grains of the preliminary sub-layers including titanium (Ti) and gaps between the grains may increase, and generation of a titanium oxide (TiOₓ) formed by introducing an O₂ gas between the grains may be prevented. The second preliminary partition wall layer L2-I on which a titanium oxide (TiOₓ) is not formed may be easily etched, and generation of a cone-shaped residue formed due to non-etching of the first preliminary partition wall layer L1-I may be reduced or removed. Thus, pixel defects in the display panel DP (see FIG. 7O) may be reduced or removed.

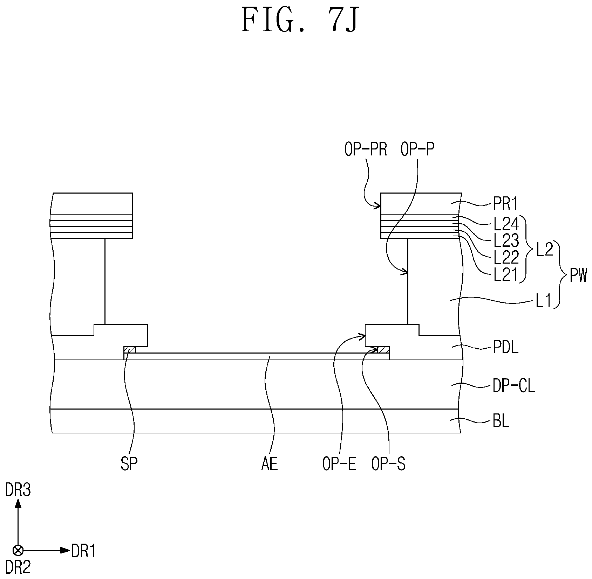

Referring to FIG. 7J, the method of manufacturing a display panel according to the present disclosure may further include an operation of etching the pixel defining film PDL to form the light emitting opening OP-E overlapping the partition wall opening OP-P and an operation of etching the sacrificial layer SP-I (see FIG. 7I) to form the sacrificial pattern SP having the sacrificial opening OP-S overlapping the light emitting opening OP-E.

In the operation of etching the pixel defining film PDL, the pixel defining film PDL may be dry-etched using the first photoresist layer PR1 and the partition wall PW (e.g., the second partition wall layer L2) as a mask. A portion of the pixel defining film PDL, which does not overlap the first photoresist layer PR1 and the partition wall PW, may be etched and removed. As a result, the light emitting opening OP-E overlapping the partition wall opening OP-P may be formed in the pixel defining film PDL.

In the operation of etching the sacrificial layer SP-I, the sacrificial layer SP-I may be wet-etched using the first photoresist layer PR1 and the partition wall PW (e.g., the second partition wall layer L2) as a mask. A portion of the sacrificial layer SP-I, which does not overlap the first photoresist layer PR1 and the partition wall PW, may be etched and removed. As a result, the sacrificial pattern SP may be formed from the sacrificial layer SP-I.

The process of etching the sacrificial pattern SP may be performed in an environment in which an etching selection ratio between the sacrificial pattern SP and the anode AE is high, and therefore, the anode AE may be prevented from being etched together. That is, the sacrificial pattern SP having a higher etch rate than the anode AE may be disposed between the pixel defining film PDL and the anode AE, and thus the anode AE may be prevented from being etched and damaged together during an etching process.

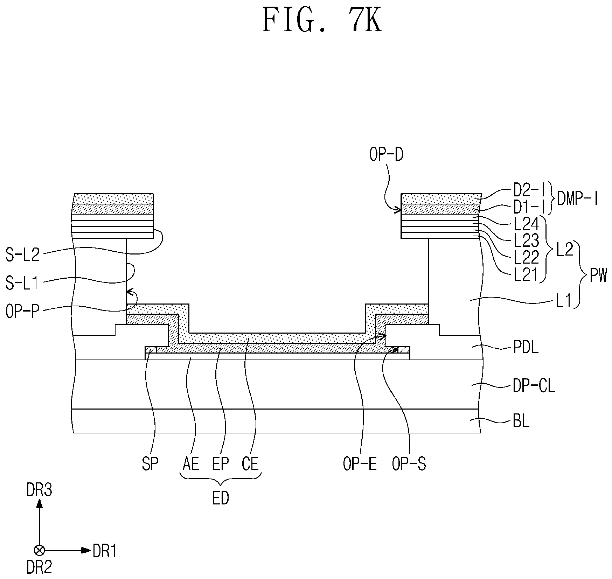

Thereafter, referring to FIG. 7K, the method of manufacturing a display panel according to an embodiment may include an operation of forming the light emitting pattern EP and the cathode CE after removing the first photoresist layer PR1 (see FIG. 7J).

The operation of forming the light emitting pattern EP may include a process of depositing a light emitting layer. For example, the operation of forming the light emitting pattern EP may include an operation of thermally depositing the light emitting layer. The light emitting layer may be separated by the tip portion formed in the partition wall PW and may be deposited inside the partition wall opening OP-P and the light emitting opening OP-E and on the partition wall PW. The light emitting layer formed inside the partition wall opening OP-P and the light emitting opening OP-E may form the light emitting pattern EP and may form a first dummy layer D1-I formed on the partition wall PW. That is, the light emitting pattern EP may be formed to overlap the partition wall opening OP-P on the anode AE, and the light emitting pattern EP may be formed such that the light emitting pattern EP covers the anode AE and the pixel defining film PDL.

The first dummy layer D1-I formed together in the operation of forming the light emitting pattern EP may include an organic material. For example, the first dummy layer D1-I may include the same material as the light emitting pattern EP. The first dummy layer D1-I may be formed simultaneously through a single process with the light emitting pattern EP and may be formed separately from the light emitting pattern EP by the undercut shape of the partition wall PW.

The operation of forming the cathode CE may include a process of depositing a cathode layer. For example, the operation of forming the cathode CE may include an operation of sputtering the cathode layer. The cathode layer may be separated by the tip portion formed in the partition wall PW and may be deposited inside the light emitting opening OP-E and the partition wall opening OP-P and on the partition wall PW. The cathode layer formed inside the light emitting opening OP-E and the partition wall opening OP-P may form the cathode CE, and the cathode layer formed on the partition wall PW may form a second dummy layer D2-I. That is, the cathode CE may be formed to overlap the partition wall opening OP-P on the light emitting pattern EP, and the cathode CE may be formed such that the cathode CE covers the light emitting pattern EP.

FIG. 7K illustrates an example that the cathode CE is formed inside the light emitting opening OP-E and the partition wall opening OP-P, but the present disclosure is not limited to the above example. For example, the cathode CE may be formed only inside the partition wall opening OP-P. Further, FIG. 7K illustrates an example that only the distal end of the cathode CE is in contact with the partition wall PW, but a deposition angle of a deposition process of forming the cathode CE may be adjusted such that the cathode CE as formed extends in contact with the inner surface of the partition wall PW.

The second dummy layer D2-I formed together in the operation of forming the cathode CE may include a conductive material. For example, the second dummy layer D2-I and the cathode CE may include the same material. The second dummy layer D2-I may be simultaneously formed through one process together with the cathode CE and formed separately from the cathode CE by the undercut shape of the partition wall PW.

The anode AE, the light emitting pattern EP, and the cathode CE may be sequentially disposed in the third direction DR3. The anode AE, the light emitting pattern EP, and the cathode CE may form the light emitting element ED. The first dummy layer D1-I and the second dummy layer D2-I may be sequentially disposed on an upper surface of the partition wall PW in the third direction DR3. The first dummy layer D1-I and the second dummy layer D2-I may form a dummy layer DMP-I, and a dummy opening OP-D may be defined in the dummy layer DMP-I.

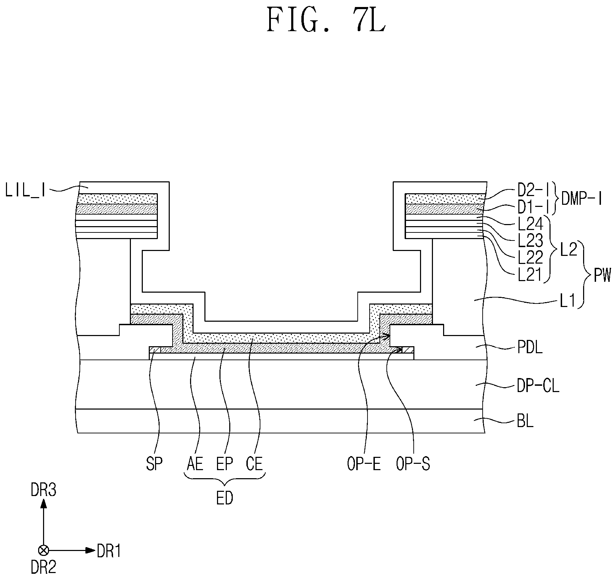

Thereafter, referring to FIGS. 7L and 7M, the method of manufacturing a display panel according to the present disclosure may further include an operation of forming the lower encapsulation inorganic pattern LIL on the cathode CE. The operation of forming the lower encapsulation inorganic pattern LIL may include an operation of depositing a lower encapsulation inorganic layer LIL_I on the cathode CE and an operation of forming the lower encapsulation inorganic pattern LIL by etching the lower encapsulation inorganic layer LIL_I.

As illustrated in FIG. 7L, the operation of forming the lower encapsulation inorganic pattern LIL (see FIG. 7M) may include an operation of depositing the lower encapsulation inorganic layer LIL_I. In an embodiment, the lower encapsulation inorganic layer LIL_I may be formed through a chemical vapor deposition (CVD) process. The lower encapsulation inorganic layer LIL_I may be formed such that the lower encapsulation inorganic layer LIL_I covers the cathode CE and the partition wall PW.

As illustrated in FIG. 7M, a second photoresist layer PR2 may be formed on the lower encapsulation inorganic layer LIL_I. In an operation of forming the second photoresist layer PR2, the second photoresist layer PR2 may be formed by forming a preliminary photoresist layer and then patterning the preliminary photoresist layer using a photo mask. Through the patterning process, the second photoresist layer PR2 may be formed in a pattern shape corresponding to the light emitting element ED.

The operation of forming the lower encapsulation inorganic pattern LIL may include an operation of removing a portion of the lower encapsulation inorganic layer LIL_I (see FIG. 7L), which does not overlap the light emitting element ED. In the operation of removing the portion of the lower encapsulation inorganic layer LIL_I, which does not overlap the light emitting element ED, the lower encapsulation inorganic layer LIL_I may be dry-etched using the second photoresist layer PR2 as a mask. A portion of the lower encapsulation inorganic layer LIL_I, which does not overlap the second photoresist layer PR2, may be removed, and a portion of the lower encapsulation inorganic layer LIL_I, which is not etched, may form the lower encapsulation inorganic pattern LIL.

The portion of the lower encapsulation inorganic pattern LIL, which is formed through the etching, may be formed inside the partition wall opening OP-P, and the other portion of the lower encapsulation inorganic pattern LIL may be formed on the partition wall PW. The other portion of the lower encapsulation inorganic pattern LIL may be spaced apart from the upper surface of the partition wall PW on a cross section.

The method of manufacturing a display panel according to the present disclosure may further include an operation of etching the dummy layer DMP-I (see FIG. 7L). In an operation of patterning the dummy layer DMP-I, the first dummy layer D1-I and the second dummy layer D2-I (see FIG. 7L) may be dry-etched, and thus portions of the first dummy layer D1-I and the second dummy layer D2-I (see FIG. 7L), which do not overlap the second photoresist layer PR2, may be removed.

A first dummy pattern D1 and a second dummy pattern D2 overlapping the corresponding light emitting opening OP-E may be formed from the patterned first dummy layer D1-I and the patterned second dummy layer D2-I, and thus the dummy patterns DMP including the first dummy pattern D1 and the second dummy pattern D2 may be formed. The first dummy pattern D1 and the second dummy pattern D2 may have a closed-line shape surrounding the corresponding light emitting areas PXA-R, PXA-G, and PXA-B (see FIG. 4) on a plane.

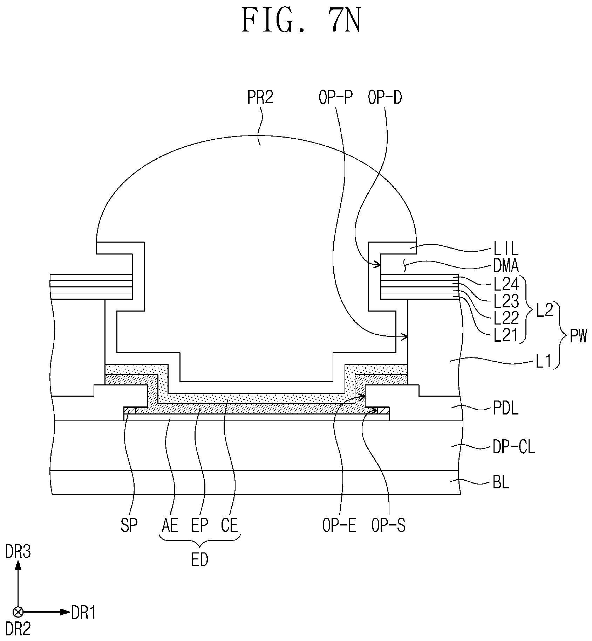

Thereafter, referring to FIG. 7N, the method of manufacturing a display panel according to the present disclosure may further include an operation of removing the dummy patterns DMP (see FIG. 7M).

In the operation of removing the dummy patterns DMP, the dummy patterns DMP formed on the partition wall PW may be wet-etched, and thus the dummy patterns DMP may be removed. An area from which the dummy patterns DMP are removed may be defined as the dummy area DMA. That is, the dummy area DMA may be formed between the partition wall PW and the lower encapsulation inorganic pattern LIL on a cross section.

In an embodiment of the present disclosure, the operation of removing the dummy patterns DMP may be omitted. In this case, the encapsulation organic film OL and the upper encapsulation inorganic film UIL of FIG. 7O may be formed in a state in which the dummy patterns DMP remain.

Thereafter, referring to FIG. 7O, the method of manufacturing a display panel according to the present disclosure may further include an operation of completing the display panel DP by removing the second photoresist layer PR2 (see FIG. 7M) and then forming the encapsulation organic film OL and the upper encapsulation inorganic film UIL. The encapsulation organic film OL may be formed by applying an organic material in an inkjet method, but embodiments of the present disclosure are not limited thereto. The encapsulation organic film OL provides a flattened upper surface. Thereafter, the upper encapsulation inorganic film UIL may be formed by depositing an inorganic material. Therefore, the display panel DP including the base layer BL, the circuit element layer DP-CL, the display element layer DP-OLED, and the thin film encapsulation Layer TFE may be formed.

An operation of forming the partition wall opening and the light emitting opening corresponding to the light emitting areas having different colors in the partition wall PW and the pixel defining film PDL, an operation of forming the light emitting elements providing different colors, and an operation of forming the lower encapsulation inorganic pattern covering the light emitting elements providing different colors may be further performed between the operation of the lower encapsulation inorganic pattern LIL and the operation of completing the display panel DP. Therefore, the display panel DP including the first to third light emitting elements corresponding to the plurality of light emitting areas PXA-R, PXA-G, and PXA-B illustrated in FIG. 4 and the lower encapsulation inorganic patterns corresponding to the first to third light emitting elements may be formed.

According to the above description, a second partition wall layer may be divided and deposited into a plurality of sub-layers, and thus sizes of grains of the plurality of sub-layers may be limited. Accordingly, the sizes of the grains of the sub-layers including titanium (Ti) and gaps between the grains may increase, and generation of a titanium oxide (TiOₓ) formed by introducing an O₂ gas between the grains may be prevented. The second partition wall layer on which the titanium oxide TiOₓ is not formed may be easily etched, and generation of cone-shaped residue formed due to non-etching of a first partition wall layer may be reduced or removed. Thus, pixel defects in a display panel may be reduced or removed.

Although the description has been made above with reference to an embodiment of the present disclosure, it may be understood that those skilled in the art or those having ordinary knowledge in the art may variously modify and change the present disclosure without departing from the technical scope of the present disclosure described in the appended claims. Thus, the technical scope of the present disclosure is not limited to the detailed description of the specification but should be defined by the appended claims.

## Claims

1. A display panel comprising:
a base layer;
a pixel defining film disposed on the base layer and having a light emitting opening;
a partition wall disposed on the pixel defining film and having a partition wall opening overlapping the light emitting opening; and
a light emitting element comprising an anode, an intermediate layer, and a cathode, wherein the cathode is in contact with the partition wall and disposed inside the light emitting opening and the partition wall opening,
wherein the partition wall comprises:
a first partition wall layer disposed on the pixel defining film; and
a second partition wall layer comprising a plurality of sub-layers repeatedly disposed on the first partition wall layer, and
wherein the first partition wall layer has an undercut shape with respect to the second partition wall layer.

2. The display panel of claim 1, wherein each of the plurality of sub-layers comprises titanium (Ti) or a titanium nitride (TiN).

3. The display panel of claim 1 or claim 2, wherein:
the partition wall opening comprises:
a first area defined by an inner surface of the first partition wall layer; and
a second area defined by an inner surface of the second partition wall layer, and
a width of the first area in a direction is greater than a width of the second area in the direction.

4. The display panel of any one of claims 1 to 3, wherein a thickness of the second partition wall layer is 2,000 Å or more.

5. The display panel of any one of claims 1 to 4, wherein a quantity of sub-layers comprised in the second partition wall layer ranges from two to ten.

6. The display panel of any one of claims 1 to 5, wherein a thickness of each of the plurality of sub-layers ranges from 200 Å to 1,000 Å.

7. The display panel of any one of claims 1 to 6, wherein:
the plurality of sub-layers comprise a first sub-layer, a second sub-layer, a third sub-layer, and a fourth sub-layer sequentially arranged in a thickness direction of the base layer, and
grains of a sub-layer comprised among the first sub-layer, the second sub-layer, the third sub-layer, and the fourth sub-layer are distinguished from grains of another sub-layer which is comprised among the first sub-layer, the second sub-layer, the third sub-layer, and the fourth sub-layer and adjacent the sub-layer.

8. The display panel of claim 7, wherein:
(i) the first sub-layer and the third sub-layer comprise titanium (Ti), and
the second sub-layer and the fourth sub-later comprise a titanium nitride (TiN); and/or
(ii) a thickness of each of the first sub-layer, the second sub-layer, the third sub-layer, and the fourth sub-layer ranges from 400 Å to 600 Å.

9. The display panel of any one of claims 1 to 6, wherein:
the plurality of sub-layers comprise:
a first sub-layer disposed on the first partition wall layer;
a second sub-layer disposed on the first sub-layer; and
a third sub-layer disposed on the second sub-layer, and
grains of a sub-layer comprised among the first sub-layer, the second sub-layer, and the third sub-layer are distinguished from grains of another sub-layer which is comprised among the first sub-layer, the second sub-layer, and the third sub-layer and adj acent the sub-layer, optionally wherein a thickness of each of the first sub-layer, the second sub-layer, and the third sub-layer ranges from 600 Å to 800 Å.

10. A method of manufacturing a display panel, the method comprising:
providing a preliminary display panel comprising a base layer and a pixel defining film disposed on the base layer;
forming a first preliminary partition wall layer on the preliminary display panel;
forming a second preliminary partition wall layer comprising a plurality of preliminary sub-layers on the first preliminary partition wall layer;
forming a first partition wall layer and a second partition wall layer comprising a plurality of sub-layers by etching the first preliminary partition wall layer and the second preliminary partition wall layer; and
forming a light emitting pattern and a cathode,
wherein:
the forming of the first partition wall layer and the second partition wall layer comprises forming a partition wall opening,
the partition wall opening comprises a first area defined by an inner surface of the first partition wall layer and a second area defined by an inner surface of the second partition wall layer, and
a width of the first area in a direction is greater than a width of the second area in the direction.

11. The method of claim 10, wherein the forming of the second preliminary partition wall layer comprising the plurality of preliminary sub-layers on the first preliminary partition wall layer comprises:
forming a first preliminary sub-layer on the first preliminary partition wall layer inside a chamber;
changing temperatures or contact gaseous environments of the preliminary display panel, the first preliminary partition wall layer, and the first preliminary sub-layer; and
forming a second preliminary sub-layer on the first preliminary sub-layer inside the chamber, optionally wherein the changing of the temperatures or the contact gaseous environments of the preliminary display panel, the first preliminary partition wall layer, and the first preliminary sub-layer comprises:
moving the preliminary display panel, the first preliminary partition wall layer, and the first preliminary sub-layer arranged inside the chamber to outside of the chamber.

12. The method of claim 10 or claim 11, wherein the forming of the second preliminary partition wall layer comprising the plurality of preliminary sub-layers on the first preliminary partition wall layer comprises:
depositing preliminary sub-layers having a thickness ranging from 200 Å to 1,000 Å, wherein a quantity of the preliminary sub-layers ranges from two to ten, and
wherein each of the plurality of preliminary sub-layers comprises titanium (Ti) or a titanium nitride (TiN).

13. The method of any one of claims 10 to 12, wherein the forming of the second preliminary partition wall layer comprising the plurality of preliminary sub-layers on the first preliminary partition wall layer comprises:
depositing a first preliminary sub-layer having a thickness ranging from 400 Å to 600 Å on the first preliminary partition wall layer;
depositing a second preliminary sub-layer having a thickness ranging from 400 Å to 600 Å on the first preliminary sub-layer;
depositing a third preliminary sub-layer having a thickness ranging from 400 Å to 600 Å on the second preliminary sub-layer; and
depositing a fourth preliminary sub-layer having a thickness ranging from 400 Å to 600 Å on the third preliminary sub-layer, optionally wherein:
the first preliminary sub-layer and the third preliminary sub-layer comprise titanium (Ti), and
the second preliminary sub-layer and the fourth preliminary sub-layer comprise a titanium nitride (TiN).

14. The method of any one of claims 10 to 12, wherein the forming of the second preliminary partition wall layer comprising the plurality of preliminary sub-layers on the first preliminary partition wall layer comprises:
depositing a first preliminary sub-layer having a thickness ranging from 600 Å to 800 Å on the first preliminary partition wall layer;
depositing a second preliminary sub-layer having a thickness ranging from 600 Å to 800 Å on the first preliminary sub-layer; and
depositing a third preliminary sub-layer having a thickness ranging from 600 Å to 800 Å on the second preliminary sub-layer.

15. An electronic device which provides an image,
the electronic device comprising:
a window;
a display panel disposed below the window; and
a housing disposed below the display panel and coupled with the window, wherein an inner space of the housing accommodates the display panel,
the display panel comprising:
a base layer;
a pixel defining film disposed on the base layer and having a light emitting opening;
a partition wall disposed on the pixel defining film and having a partition wall opening overlapping the light emitting opening; and
a light emitting element comprising an anode, an intermediate layer, and a cathode, wherein the cathode is in contact with the partition wall and disposed inside the light emitting opening and the partition wall opening, wherein the partition wall comprises:
a first partition wall layer disposed on the pixel defining film; and
a second partition wall layer comprising a plurality of sub-layers repeatedly disposed on the first partition wall layer, and
wherein the first partition wall layer has an undercut shape with respect to the second partition wall layer, optionally wherein:
each of the plurality of sub-layers comprises titanium (Ti) or a titanium nitride (TiN), and
a thickness of each of the plurality of sub-layers ranges from 200 Å to 1,000 Å.
